# EUROPEAN PATENT APPLICATION

(11) **EP 4 651 673 A2**
(43) Date of publication of application: **19.11.2025**
(21) Application number: 25168904.8
(22) Date of filing: 07.04.2025
(51) Int. Cl.: H10D 84/01, H10D 30/01, H10D 30/00, H10D 84/03, H10D 88/00

(54) **HIGH-DENSITY STACKED TRANSISTORS WITH INDEPENDENT GATES**

(30) Priority: 16.05.2024 US 202418666096
(71) Applicant: Intel Corporation, Santa Clara, CA 95054 (US)
(72) Inventor: GHANI, Tahir, Portland, OR 97229 (US); SHARMA, Abhishek A., Portland, OR 97229 (US); GOMES, Wilfred, Portland, OR 97229 (US); MURTHY, Anand S., Portland, OR 97229 (US)
(74) Representative: Samson & Partner Patentanwälte mbB

(57) **Abstract**

A vertical stack of three-dimensional transistors, such as nanoribbon-based transistors, includes a stack of nanoribbons with independent gates around subsets of nanoribbons in the stack. In previous nanoribbon transistors, a gate electrode wraps around all of the semiconductor regions and spans the areas between adjacent semiconductor regions, thus electrically coupling the centers of the semiconductor regions. To achieve a stack of semiconductor regions with independent gates, adjacent nanoribbons in the stack may be set at different distances apart, or two or more sacrificial materials may be included when forming the stack of semiconductor materials and selectively etched when forming different gates.

## Description

### Background

Non-planar transistors are three-dimensional electronic devices that deviate from a traditional flat transistor design. Compared to planar transistors, non-planar transistors can provide improved control over current flow, reduced leakage, and enhanced performance, making it a key technology for smaller, faster, and more energy-efficient electronic devices. Examples of non-planar transistors include fin-shaped field-effect transistors, referred to as FinFETs, and gate-all-around (GAA) transistors. GAA transistors, also referred to as surrounding-gate transistors, have a gate material that surrounds a channel region on all sides. GAA transistors may be nanoribbon-based or nanowire-based.

Non-planar transistors may use a monocrystalline material, such as monocrystalline silicon, to form semiconductor channels. For example, alternating layers of different monocrystalline materials (e.g., silicon and germanium) can be grown in layers. One of the materials is a sacrificial material that is removed during processing to form stacks of the channel material. A gate stack that may include one or more gate electrode materials and a gate dielectric is provided around a central portion of the semiconductor channel. A source region and a drain region are provided on the opposite ends of the semiconductor channel, forming, respectively, a source and a drain of the transistor. The source and drain regions are insulated from the gate stack, so that the voltages at the three terminals (gate, source, and drain) may be separately controlled.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1A is a cross-section across a nanoribbon-based transistor showing the source, gate, and drain.
FIG. 1B is a cross-section of the nanoribbon-based transistor through the plane AA' in FIG. 1A.
FIG. 2A is a cross-section illustrating two stacked transistors formed around nanoribbons, according to some embodiments of the present disclosure.
FIG. 2B is a gate cross-section through the plane CC' in FIG. 2A, according to some embodiments of the present disclosure.
FIG. 3 is a flow diagram of a process for fabricating stacked transistors with independent gates, according to some embodiments of the present disclosure.
FIGs. 4A and 4B are two perpendicular cross-sections illustrating layers of a channel material and a sacrificial material, according to some embodiments of the present disclosure.
FIGs. 5A and 5B are two perpendicular cross-sections illustrating individuated stacks of the layered channel material and sacrificial material, according to some embodiments of the present disclosure.
FIGs. 6A and 6B are two perpendicular cross-sections illustrating formation of anchors around the stacks of the layered channel material and sacrificial material, according to some embodiments of the present disclosure.
FIGs. 7A and 7B are two perpendicular cross-sections illustrating removal of the sacrificial material from the stacks, according to some embodiments of the present disclosure.
FIGs. 8A and 8B are two perpendicular cross-sections illustrating a gate stack deposited around the channels, according to some embodiments of the present disclosure.
FIG. 9A is a cross-section illustrating three stacked transistors formed around nanoribbons with different gate stacks, according to some embodiments of the present disclosure.
FIG. 9B is a gate cross-section through the plane EE' in FIG. 9A, according to some embodiments of the present disclosure.
FIG. 9C is an expanded gate cross-section through the plane EE' in FIG. 9A, according to some embodiments of the present disclosure.
FIG. 10 is a flow diagram of a process for fabricating stacked transistors with different gate stacks formed around nanoribbons, according to some embodiments of the present disclosure.
FIGs. 11A and 11B are two perpendicular cross-sections illustrating layers of a channel material and two sacrificial materials, according to some embodiments of the present disclosure.
FIGs. 12A and 12B are two perpendicular cross-sections illustrating individuated stacks of the layered channel material and sacrificial materials, according to some embodiments of the present disclosure.
FIGs. 13A and 13B are two perpendicular cross-sections illustrating formation of anchors around the stacks of the layered channel material and sacrificial materials, according to some embodiments of the present disclosure.
FIGs. 14A and 14B are two perpendicular cross-sections illustrating removal of a first sacrificial material from the stacks, according to some embodiments of the present disclosure.
FIGs. 15A and 15B are two perpendicular cross-sections illustrating a first gate stack deposited around the exposed channels, according to some embodiments of the present disclosure.
FIGs. 16A and 16B are two perpendicular cross-sections illustrating removal of the second sacrificial material from the stacks, according to some embodiments of the present disclosure.
FIGs. 17A and 17B are two perpendicular cross-sections illustrating a second gate stack deposited around the exposed channels, according to some embodiments of the present disclosure.
FIGs. 18A and 18B illustrate two steps in forming a staircase structure for the gate vias, according to some embodiments of the present disclosure.
FIG. 19A is an example stack of materials for forming stacked transistors with different channel materials and different gate stacks, in accordance with any of the embodiments disclosed herein.
FIG. 19B is an example gate cross-section of stacked transistors with different channel materials and different gate stacks formed from the stack shown in FIG. 19A, in accordance with any of the embodiments disclosed herein.
FIG. 20A is an example stack of materials for forming stacked transistors with different gate materials in a single transistor, in accordance with any of the embodiments disclosed herein.
FIG. 20B is an example gate cross-section of stacked transistors with different gate materials in a single transistor formed from the stack shown in FIG. 20A, in accordance with any of the embodiments disclosed herein.
FIG. 21 is a top view of a wafer and dies that include one or more stacked transistors with independent gates in accordance with any of the embodiments disclosed herein.
FIG. 22 is a cross-sectional side view of an IC device that may include one or more stacked transistors with independent gates in accordance with any of the embodiments disclosed herein.
FIG. 23 is a cross-sectional side view of an IC device assembly that may include one or more stacked transistors with independent gates in accordance with any of the embodiments disclosed herein.
FIG. 24 is a block diagram of an example computing device that may include one or more stacked transistors with independent gates in accordance with any of the embodiments disclosed herein.
FIG. 25 is a block diagram of an example processing device that includes an IC device with one or more stacked transistors with independent gates in accordance with any of the embodiments disclosed herein.

### Detailed Description

### Overview

The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

Transistors typically include a gate stack coupled to a semiconductor channel, which may be a nanoribbon or a stack of nanoribbons. A gate stack often includes a gate electrode and a gate dielectric, with the gate dielectric formed between the gate electrode and the channel material. In a GAA transistor, the gate dielectric is formed around each semiconductor region (e.g., each nanoribbon), and the gate electrode is formed over and around the gate dielectric, including in spaces between adjacent semiconductor regions. In some implementations of GAA transistors, the gate dielectric is omitted. A source region is formed at one end of the semiconductor regions, and a drain region is formed at the opposite end of the semiconductor regions, thus realizing a three-terminal device.

Described herein are IC devices that include vertically stacked non-planar or three-dimensional transistors, such as nanoribbon-based transistors. In previous GAA transistors, the gate electrode wraps around all of the semiconductor regions and spans the areas between adjacent semiconductor regions, thus electrically coupling the centers of the semiconductor regions. The methods disclosed herein enable fabrication of stacked transistors with independent gates. For example, variation in spacing of the semiconductor regions, or using two or more sacrificial materials when forming the stack of semiconductor materials, can enable creation of independent gates.

In some embodiments, different transistors may have different strengths, e.g., different numbers of semiconductor regions. In previous transistor architectures, semiconductor regions (e.g., semiconductor fins) were typically formed in even numbers, so that transistors formed around multiple channel regions had an even number of channel regions, e.g., two fins, four fins, or six fins. In the GAA transistors disclosed herein, any number of semiconductor regions may be combined in a transistor, e.g., one semiconductor region, two semiconductor regions, three semiconductor regions, four semiconductor regions, five semiconductor regions, etc. In a given vertical stack, different transistors may have different number of semiconductor regions, e.g., a one-nanoribbon transistor may be stacked over a two-nanoribbon transistor, or a three-nanoribbon transistor may be stacked over a one-nanoribbon transistor. The different strength transistors may be used for different functions, e.g., a relatively "strong" transistor with more semiconductor regions may be used as a pull-up or pull-down transistor, while a relatively "weak" transistor with fewer semiconductor regions may be used as a logic or data transistor. In some embodiments, at least one transistor in the stack may include an odd number of semiconductor regions (e.g., one, three, five, etc.). For example, a transistor with an odd number of semiconductor regions may be below a transistor that includes a transistor with an even number of semiconductor regions, or above a transistor that includes a transistor with an even number of semiconductor regions.

Different transistors in the stack may be different from one another in other ways. For example, different transistors may include different channel materials, different gate dielectrics, and/or different gate electrode materials. In some embodiments, a single transistor may include heterogenous materials, e.g., one transistor may include different nanoribbons of different semiconductor materials, or one transistor may include different gate dielectrics and/or different electrode materials.

Nanoribbons are often small structures, with a low amount of current passing through each individual nanoribbon. In many nanoribbon-based transistors, multiple nanoribbons are used together in a single transistor to provide adequate current flow through the transistor, as noted above. In general, when transistors operate at lower temperatures, they have improved performance. For example, electron mobility in semiconductors improves at lower temperatures, which can lead to increased drive currents across semiconductor regions, e.g., across transistors or individual nanoribbons. In addition, transistors at lower temperatures generally experience lower leakage than transistors operating at higher temperatures. These factors can allow smaller transistors when the IC device is operating at a lower temperature. In addition, the electron mobility in a single nanoribbon may be enhanced through selection of a high-mobility channel material. In some cases, e.g., in low-temperature applications where the drive current through an individual nanoribbon is greater, transistors can be built around individual nanoribbons in a stack, or a portion of nanoribbons in a stack (e.g., two or three nanoribbons), rather than around full stacks of nanoribbons.

When two independent gates are formed in a given stack, in some cases, the lower gates may be accessed through back-side contacts. In other cases, or when three or more independent gates are formed in a given stack, a gate line may be formed across multiple transistors in different stacks. For example, if multiple stacks of transistors are arranged side-by-side, a first gate line spans the top nanoribbon, or set or nanoribbons, of each stack, a second gate line spans the next nanoribbon, or set or nanoribbons, down in each stack, etc. Connections from the different gate lines to a metallization layer may be formed in a staircase fashion, as illustrated in the figures. Source or drain (S/D) regions may be coupled to all of the transistors in a given stack, so only the gates of the stacked transistors are independent.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well known features are omitted or simplified in order not to obscure the illustrative implementations.

In the following detailed description, reference is made to the accompanying drawings that form a part hereof, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. The meaning of "a," "an," and "the" include plural references. The meaning of "in" includes "in" and "on."

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. The terms "substantially," "close," "approximately," "near," and "about," generally refer to being within +/- 20% of a target value, unless specified otherwise. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art. For example, as used herein, a "logic state" of a ferroelectric memory cell refers to one of a finite number of states that the cell can have, e.g. logic states "1" and "0," each state represented by a different polarization of the ferroelectric material of the cell. In another example, as used herein, a "READ" and "WRITE" memory access or operations refer to, respectively, determining/sensing a logic state of a memory cell and programming/setting a logic state of a memory cell. In other examples, the term "connected" means a direct electrical or magnetic connection between the things that are connected, without any intermediary devices, while the term "coupled" means either a direct electrical or magnetic connection between the things that are connected or an indirect connection through one or more passive or active intermediary devices. The term "circuit" means one or more passive and/or active components that are arranged to cooperate with one another to provide a desired function. In yet another example, a "high-k dielectric" refers to a material having a higher dielectric constant (k) than silicon oxide. The terms "oxide," "carbide," "nitride," etc. refer to compounds containing, respectively, oxygen, carbon, nitrogen, etc.

In the following, some descriptions may refer to a particular S/D region or contact being either a source region/contact or a drain region/contact. However, unless specified otherwise, which region/contact of a transistor is considered to be a source region/contact and which region/contact is considered to be a drain region/contact is not important because, as is common in the field of FETs, designations of source and drain are often interchangeable. Therefore, descriptions of some illustrative embodiments of the source and drain regions/contacts provided herein are applicable to embodiments where the designation of source and drain regions/contacts may be reversed.

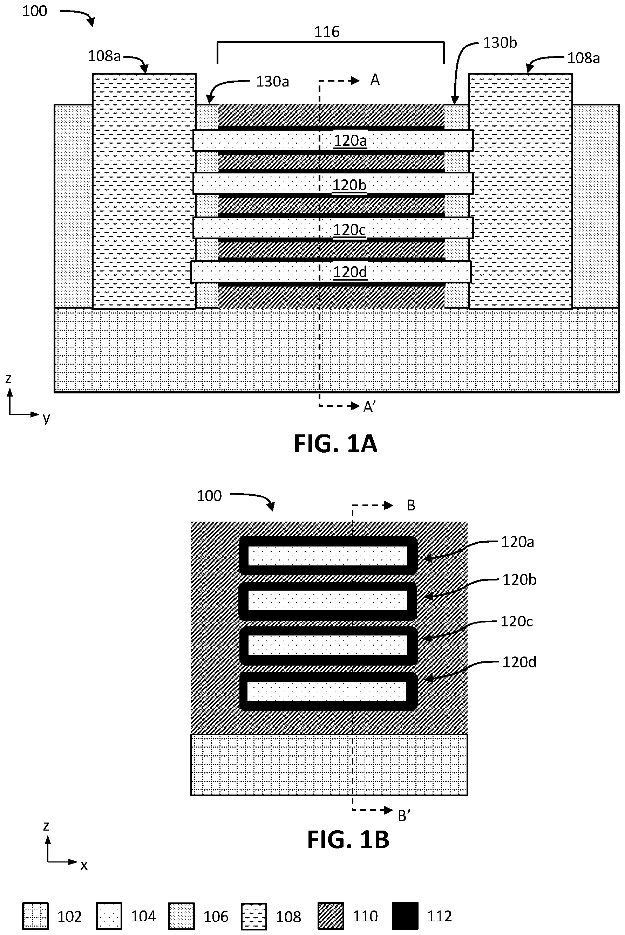

For convenience, if a collection of drawings designated with different letters are present, e.g., FIGS. 1A-1B, such a collection may be referred to herein without the letters, e.g., as "FIG. 1."

### Example nanoribbon transistor

FIGs. 1A-1B illustrate an example architecture of a nanoribbon-based transistor. FIG. 1A is a cross-section across a transistor 100 showing the source, gate, and drain. FIG. 1B is a cross-section across the gate regions of the transistor 100. FIG. 1B is a cross-section through the plane AA' in FIG. 1A, and FIG. 1A is a cross-section through the plane BB' in FIG. 1B. The nanoribbon-based transistor 100 illustrates certain structures and materials that may be used in the vertically stacked transistors with independent gates discussed further below.

A number of elements referred to in the description of FIGs. 1-20, and with reference numerals are illustrated in these figures with different patterns, with a legend at the bottom of the page showing the correspondence between the reference numerals and patterns. The legend illustrates that FIGs. 1A and 1B use different patterns to show a support structure 102, a channel material 104, a dielectric material 106, a source or drain (S/D) region 108, a gate electrode 110, and a gate dielectric 112.

In the drawings, some example structures of various devices and assemblies described herein are shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

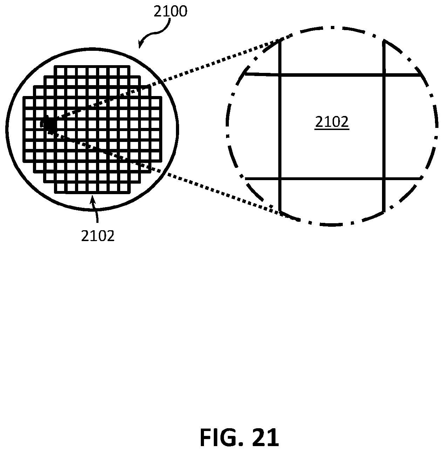

In general, implementations of the present disclosure may be formed or carried out on a support structure, e.g., the support structure 102 illustrated in FIG. 1. The support structure 102 may be, e.g., a substrate, a die, a wafer or a chip. For example, the support structure may be the wafer 2100 of FIG. 21, discussed below, and may be, or be included in, a die, e.g., the singulated die 2102 of FIG. 21, discussed below. The support structure 102 extends along the x-y plane in the coordinate system shown in FIG. 1. In some embodiments, a support structure 102 may be used during a fabrication process and later removed. For example, a top side of the transistor 100 may be attached to a second support structure (e.g., a second one of the support structures 102, which may be referred to as a carrier structure), and the support structure 102 over which the transistor 100 is formed may be removed to expose the back side of the transistor 100.

In some embodiments, a support structure may be a substrate that includes silicon and/or hafnium. More generally, the support structure may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support structure may be a printed circuit board (PCB) substrate. Although a few examples of materials from which the substrate may be formed are described here, any material that may serve as a foundation upon which a semiconductor device including one or more nanoribbon transistors, as described herein, may be built falls within the spirit and scope of the present disclosure.

In FIGs. 1A and 1B, a transistor 100 is formed over a support structure 102. The transistor 100 includes a channel material 104 formed into four nanoribbons stacked on top of each other. In other examples, the transistor 100 may include more or fewer nanoribbons, e.g., one, two, three, five, six or more nanoribbons. The channel material 104 may be a semiconductor, such as silicon or other semiconductor materials described herein.

The transistor 100 includes nanoribbons 120a, 120b, 120c, and 120d, referred to collectively as nanoribbons 120 or individually as a nanoribbon 120. Each nanoribbon 120 is at a different height in the z-direction in the orientation shown in FIGs. 1A and 1B, i.e., a different distance from the support structure 102, where the nanoribbon 120a is the greatest distance from the support structure 102, and the nanoribbon 120d is the smallest distance from the support structure 102. S/D regions 108a and 108b are formed at either end of the nanoribbon channels 120, as illustrated in FIG. 1A.

In general, to form nanoribbon channels such as the nanoribbon channels 120, alternating layers of the channel material 104 and a sacrificial material are deposited over the support structure 102. The sacrificial material is removed from the stack and replaced with other material, e.g., material for forming a gate stack 116, so the sacrificial material is not shown in FIG. 1. The channel material 104 and sacrificial material include different materials. In one example, the channel material 104 is silicon, while the sacrificial material includes silicon and germanium. The sacrificial material may be chosen to have a similar crystal structure to the channel material 104, so that monocrystalline layers of the channel material 104 (or substantially monocrystalline layers, e.g., with a grain size of at least 5 nanometers, at least 20 nanometers, at least 50 nanometers, or at least 100 nanometers) and monocrystalline layers of the sacrificial material (or substantially monocrystalline layers) may be formed over each other. In different embodiments, the channel material 104 and/or the sacrificial material may be formed of any suitable single-crystal material, such as sapphire, quartz, silicon, a compound of silicon (e.g., silicon oxide), indium phosphide, germanium or a germanium alloy (e.g., silicon germanium), gallium, arsenic (e.g., an arsenide III compound, where arsenic III is in combination with another element such as boron, aluminum, gallium, or indium), or any group III-V material (i.e., materials from groups III and V of the periodic system of elements).

More generally, the channel material 104 may be composed of semiconductor material systems including, for example, N-type or P-type materials systems. The channel material 104 may include a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. The channel material 104 may include one or more of cobalt oxide, copper oxide, ruthenium oxide, nickel oxide, niobium oxide, copper peroxide, indium telluride, molybdenite, molybdenum diselenide, tungsten diselenide, tungsten disulfide, molybdenum disulfide, N- or P-type amorphous or polycrystalline silicon, monocrystalline silicon, germanium, indium arsenide, indium gallium arsenide, indium selenide, indium antimonide, zinc antimonide, antimony selenide, silicon germanium, gallium nitride, aluminum gallium nitride, indium phosphite, black phosphorus, zinc sulfide, indium sulfide, gallium sulfide, each of which may possibly be doped with one or more of gallium, indium, aluminum, fluorine, boron, phosphorus, arsenic, nitrogen, tantalum, tungsten, and magnesium, etc.

In some cases, multiple channel materials may be included within an IC device. For example, an IC device may include both N-type metal-oxide-semiconductor (NMOS) transistors and P-type MOS (PMOS) transistors, e.g., alternating rows of NMOS and PMOS transistors. NMOS and PMOS logic can use different groups of channel material 104, e.g., silicon may be used to form an N-type semiconductor channel, while silicon germanium may be used to form a P-type semiconductor channel. In some cases, a single channel material 104 is used (e.g., silicon), and different portions (e.g., channel material to form different transistors) may include different dopants, e.g., N-type dopants for NMOS transistors and P-type dopants for PMOS transistors.

The S/D regions 108 may be formed from one or more layers of doped semiconductors, metals, metal alloys, or other materials. For example, the S/D regions 108 may include a doped semiconductor, such as silicon or another semiconductor doped with an N-type dopant or a P-type dopant. The S/D regions 108 may include multiple layers with different levels of conductivity, e.g., a doped semiconductor followed by a more highly doped semiconductor, or a semiconductor followed by metal.

A central portion of each of the nanoribbon channels 120 is surrounded by a gate stack 116, which in this example, includes a gate electrode 110 and gate dielectric 112. Nanoribbon transistors often include a gate dielectric that surrounds the nanoribbon channels 120, and a gate electrode that surrounds the gate dielectric. While not specifically shown, in some cases, the gate dielectric 112 around each nanoribbon channel 120 includes multiple layers, e.g., an oxide layer and a high-k dielectric layer. The oxide layer may be grown directly on the nanoribbon channels 120, and the high-k dielectric may surround the oxide. The oxide may include oxygen in combination with the channel material 104. For example, if the nanoribbon channels are formed from silicon, the gate dielectric 112 may include a layer of silicon oxide. The high-k dielectric may be formed over the oxide. The gate electrode 110 surrounds the gate dielectric 112, e.g., the high-k dielectric (if included). In this example, the gate electrode 110 is above and below the nanoribbon stack, and between adjacent nanoribbons 120.

The gate electrode 110 includes a conductive material, such as a metal. The gate electrode 110 may include at least one P-type work function metal or N-type work function metal, depending on whether the transistor 100 is a PMOS transistor or an NMOS transistor. For a PMOS transistor, metals that may be used for the gate electrode 110 may include, but are not limited to, ruthenium, palladium, platinum, cobalt, nickel, and conductive metal oxides (e.g., ruthenium oxide). For an NMOS transistor, metals that may be used for the gate electrode 110 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). The gate electrode 110 may include a stack of two or more metal layers, where one or more metal layers are work function metal layers and at least one metal layer is a fill metal layer.

The gate dielectric 112 may include one or more high-k dielectric materials and may include elements such as hafnium, silicon, oxygen, titanium, tantalum, lanthanum, aluminum, zirconium, barium, strontium, yttrium, lead, scandium, niobium, and zinc. Examples of high-k materials that may be used include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. The gate dielectric 112 may have a thickness between about 0.5 nanometers and 3 nanometers, including all values and ranges therein, e.g., between about 1 and 3 nanometers, or between about 1 and 2 nanometers.

Regions of the transistor 100 outside of the nanoribbons 120, gate stack 116, and S/D regions 108 are filled in with a dielectric material 106. In the region between the gate stack 116 and the S/D region 108a, the dielectric material 106 forms a first series of cavity spacers 130a; a second series of cavity spacers 130b is between the gate stack 116 and the S/D region 108b. Cavity spacers 130, also referred to as "dimple spacers" or "inner spacers," provide electrical isolation between the S/D regions 108 formed at the ends of the nanoribbons and the gate electrode 110 deposited around the nanoribbons 120.

FIG. 1 illustrates a single nanoribbon transistor 100. In IC devices, many similar or identical transistors are arranged within a transistor layer. The dielectric material 106 and/or different dielectric materials may provide isolation between different transistors, or between other conductive materials in or near the transistor layer.

### Example stacked transistors with independent gates

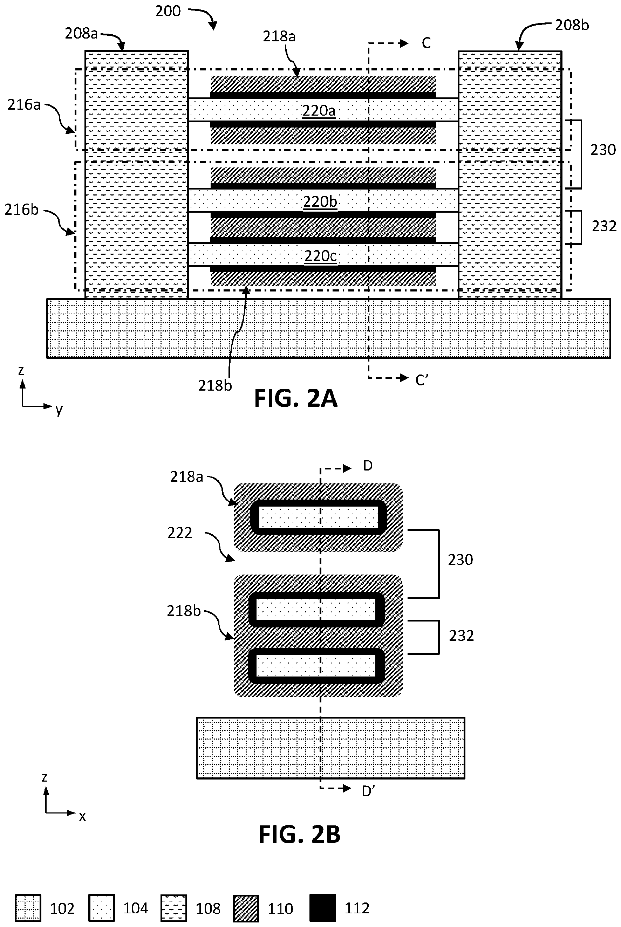

FIG. 2A is a cross-section illustrating a stack 200 of two transistors formed around nanoribbons, according to some embodiments of the present disclosure. FIG. 2B is a gate cross-section through the plane CC' in FIG. 2A. FIG. 2A illustrates the plane DD' in FIG. 2B.

Turning first to FIG. 2A, a stack of three semiconductor regions are over a support structure 102, which may be the support structure 102 described with respect to FIG. 1. In this example, the semiconductor regions are illustrated as nanoribbons 220a, 220b, and 220c. A first transistor 216a is formed over the uppermost nanoribbon 220a, and a second transistor 216b is formed around the lower two nanoribbons 220b and 220c.

The nanoribbons 220 include the channel material 104, which may be the channel material 104 described with respect to FIG. 1. The nanoribbons 220a, 220b, and 220c are referred to collectively as nanoribbons 220 or individually as a nanoribbon 220. The nanoribbons 220 may be any three-dimensional semiconductor structures around which the transistors described herein may be formed, including, for example, nanowires with a square or circular cross-section, or nanosheets with a wider rectangular cross section. The term nanosheet is sometimes used to highlight the relative breadth and thinness of a particular nanoribbon structure. For example, the term nanosheet may indicate that a structure has a small height (in the z-direction in the example coordinate system) and a broader width (into the page in FIG. 2A, i.e., in the x-direction in the coordinate system shown) compared to other nanostructures, like nanowires. In other embodiments, the nanoribbons 220 may have cross-sections that are squares with rounded corners, rectangles with rounded corners, ovals, or other shapes. In some embodiments, the nanoribbons 220 are oriented in a perpendicular direction to that shown, with a height (in the z-direction) greater than the width (in the x-direction); in such embodiments, the nanoribbons 220 may be referred to as fins. In still other embodiments, the nanoribbons 220 are coupled on one side (e.g., on the right side in the orientation shown in FIG. 2A) to a dielectric fin, and another set of nanoribbons extend from the opposite side of the dielectric fin, thus forming a forksheet arrangement.

The nanoribbons 220 each have an elongated structure that extends over the support structure 102. Each nanoribbon 220 extends primarily in the y-direction in the coordinate system used in FIGs. 2A and 2B, and thus the nanoribbon structures are considered to be elongated in this direction. The direction in which the nanoribbons 220 extend is parallel to the support structure 102; this direction in which the nanoribbons 220 extend is also parallel to the other nanoribbons in the stack. While a stack of three nanoribbons 220a-220c is shown, forming the stack 200 of two transistors, in other embodiments, the stack of nanoribbons may include more or fewer nanoribbons, e.g., two, four, five, six or more nanoribbons 220. Furthermore, in other embodiments, a different number of transistors with a different number of independent gates (e.g., three transistors, four transistors, five transistors, etc.) may be formed.

Each nanoribbon 220 is at a different height in the z-direction in the orientation shown in FIGs. 2A and 2B, i.e., a different distance from the support structure 102, where the nanoribbon 220a is the greatest distance from the support structure 102, and the nanoribbon 220c is the smallest distance from the support structure 102. In this example, the nanoribbons 220 are unevenly spaced; a first distance 230 is between the nanoribbons 220a and 220b, and a second distance 232 is between the nanoribbons 220b and 220c, where the second distance 232 is less than the first distance 230.

A first S/D region 208a is at one end of the nanoribbons 220, and a second S/D region 208b is at the opposite end of the nanoribbons 220. The S/D regions 208a and 208b may include the S/D materials 108 described with respect to FIG. 1. The first S/D region 208a is physically and electrically coupled to each of the nanoribbons 220 in the stack, and the second S/D region 208b is physically and electrically coupled to each of the nanoribbons 220 in the stack. Thus, each of the S/D regions 208a and 208b short the nanoribbons together at each respective end of the nanoribbons.

A central portion of the nanoribbon 220a is surrounded by a gate stack 218a, which like the gate stack 116, includes a gate electrode 110 and gate dielectric 112. The gate dielectric 112 surrounds the nanoribbon 220a, and the gate electrode 110 surrounds the gate dielectric 112. Central portions of the nanoribbons 220b and 220c are surrounded by a gate stack 218b, which also includes the gate electrode 110 and gate dielectric 112. The gate dielectric 112 surrounds each of the nanoribbons 220b and 220c, and the gate electrode 110 surrounds the gate dielectric 112. In the gate stack 218b, the gate dielectric 112 and gate electrode 110 span the height between the nanoribbons 220b and 220c, so that the gate electrode 110 electrically couples the nanoribbons 220b and 220c. The gate stack 218b is electrically and physically isolated from the gate stack 218a. As illustrated in FIG. 2B, a gap 222 is between the gate stack 218a and gate stack 218b. This gap 222 may be filled in with a dielectric material, e.g., the dielectric material 106 described with respect to FIG. 1. More generally, while not specifically, shown, regions of the device outside of the nanoribbons 220, gate stacks 218, and S/D regions 208 may be filled in with a dielectric material, e.g., the dielectric material 106.

The gate dielectric 112 and gate electrode 110 may include any of the materials described with respect to FIG. 1. As described with respect to FIG. 1, in some cases, the gate dielectric 112 includes multiple layers, e.g., an oxide layer and a high-k dielectric layer. The oxide layer may be grown directly on the nanoribbons 220, and the high-k dielectric may surround the oxide. The oxide may include oxygen in combination with the channel material 104. The gate electrode 110 may also include multiple layers, e.g., layers of different conductive materials.

In FIG. 1, the gate electrode 110 spanned areas between adjacent nanoribbons 120, e.g., the gate electrode 110 filled in the area between the nanoribbons 120a and 120b. In contrast, in FIG. 2A, the gate electrodes around the different transistors 216a and 216b are physically and electrically isolated from each other. Thus, an individual nanoribbon (e.g., nanoribbon 220a) may have its own independent gate stack (e.g., the gate stack 218a), or a subset of the nanoribbons (e.g., the nanoribbons 220b and 220c, which are adjacent to each other in the stack of nanoribbons) may be jointly controlled by a gate stack (e.g., the gate stack 218b). This results in transistors with different strengths, e.g., the transistor 216b may be considered to have double the strength of the transistor 216a. Transistors with different relative strengths may be formed, e.g., a transistor with three nanoribbons may have three times the strength of the transistor 216a.

To obtain independent gate stacks, the distance 230 between adjacent nanoribbons 220 in different transistors may be relatively large, e.g., larger than the distance between adjacent nanoribbons 220 in the same transistor (e.g., the distance 232 between the nanoribbons 220b and 220c). The independent gate stacks enables the formation of independent transistors that are vertically stacked. Vertically stacking transistors in this manner can provide higher transistor density compared to architecture in which transistors are formed in a single layer.

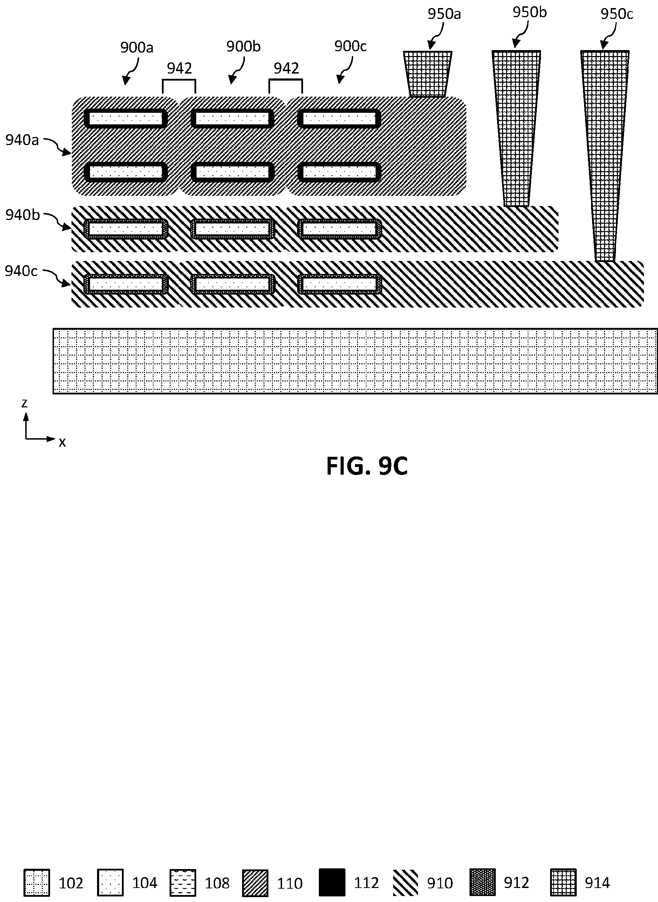

FIG. 2B is a gate cross-section through the plane CC' in FIG. 2A. As noted above, the gate stacks 216a and 216b are not connected and are electrically isolated. In some embodiments, transistors at different positions in the x-direction may be coupled together at their gate stacks, e.g., as shown in FIG. 9C. In other embodiments, a front-side or top-side contact is coupled to the gate stack 218a, while a back-side or bottom contact is coupled to the gate stack 218b. The top-side contact may extend upward from a top of the gate stack 218a, while the back-side contact may extend downward from a bottom of the gate stack 218b, i.e., towards the support structure 102. In such embodiments, at least a portion of the support structure 102 may be removed (e.g., by wafer thinning or grinding) to access the back side of the second transistor 216b.

### Example process for fabricating stacked transistors with independent gates

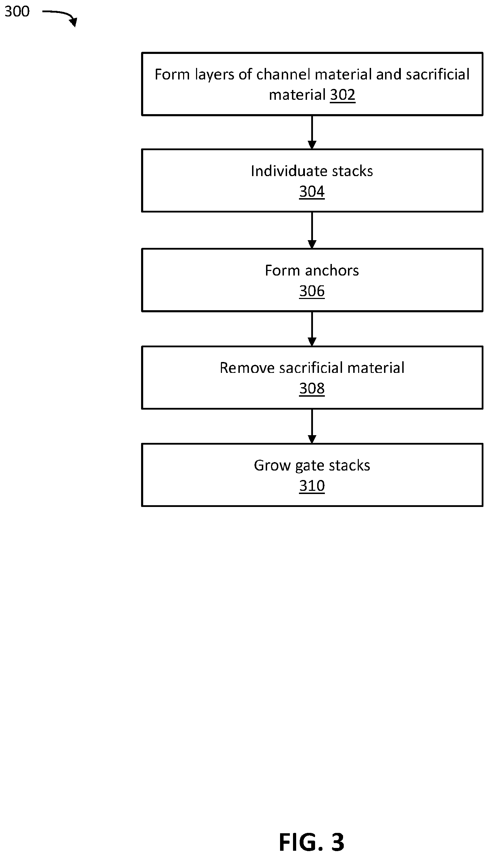

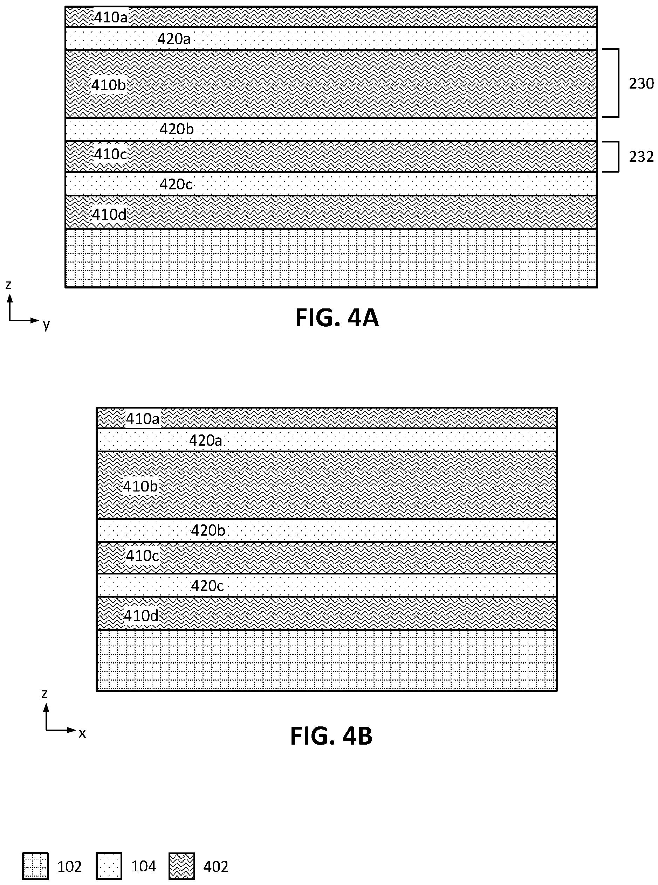

FIG. 3 is a flow diagram of a process 300 for fabricating stacked transistors with independent gates, according to some embodiments of the present disclosure. FIGs. 4-8 illustrate various steps in the processing method 300 of FIG. 3, according to some embodiments of the present disclosure. In general, the processing method 300 is performed across a wafer, with many individual stacks of transistors (or stacks of memory devices including the stacks of transistors) formed on the wafer. FIGs. 4-8 illustrate cross-sections of processing steps across several stacks of transistors. The processing method 300 describes a process of fabricating independent gates across several stacks of semiconductor regions (e.g., nanoribbons). Additional steps may be performed before, during, and/or after the process 300 to produce a device that includes the stacked transistors with independent gates.

At 302, a process for forming layers of a channel material and sacrificial material is performed. To produce a stack of GAA transistors with independent gates, the channel material may be formed in layers, with alternating layers of a sacrificial material and a channel material. The layers of the channel material and sacrificial material may be formed to provide larger gaps between some layers of channel material than others, e.g., to produce the larger distance 230 and smaller distance 232 between adjacent channels, as described with respect to FIG. 2 and illustrated in FIGs. 4-8.

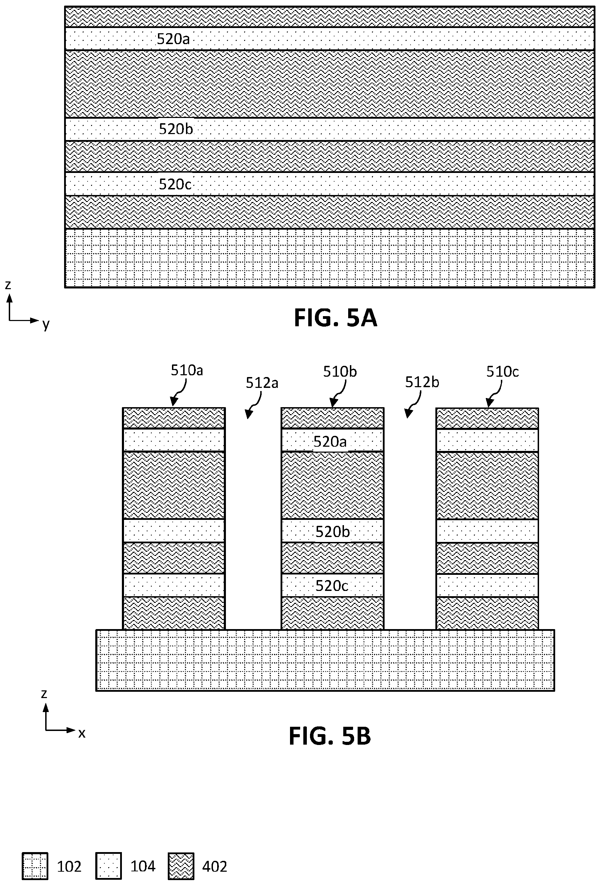

FIGs. 4A and 4B are two perpendicular cross-sections illustrating layers of a channel material and sacrificial material, according to some embodiments of the present disclosure. FIG. 4A is a cross-section in the y-z plane, and FIG. 4B is a cross-section in the x-z plane. FIGs. 5-8 illustrate the same two cross-sections at different stages of the processing method.

FIGs. 4A and 4B illustrate three layers 420a-420c of the channel material 104 interspersed with layers 410a-410d of a sacrificial material 402. In this example, three layers of the channel material 104 are illustrated; in other examples, fewer or additional layers may be included. A layer 410d of the sacrificial material 402 is over the support structure 102, followed by a layer 420c of the channel material 104, followed by another layer 410c of the sacrificial material 402, followed by another layer 420b of the channel material 104, and so forth. This pattern may generally be followed moving upwards until a desired number of layers of the channel material 104 are formed.

In this example, different layers of the sacrificial material 402 may have different thicknesses to form a stack of semiconductor regions with specific spacing. For example, the layer 410b of the sacrificial material 402 has a thickness 230, corresponding to the first distance 230 between the nanoribbon 220a and nanoribbon 220b in FIG. 2. The layer 410c of the sacrificial material 402 has a thickness 232, corresponding to the second distance 232 between the nanoribbon 220b and nanoribbon 220c in FIG. 2.

The channel material 104 and sacrificial material 402 include different materials. In one example, the channel material 104 is silicon, and the sacrificial material 402 is germanium. In another example, the channel material 104 is silicon, and the sacrificial material 402 includes a mixture of silicon and germanium. The sacrificial material 402 may be chosen to have a similar crystal structure to the channel material 104, so that monocrystalline layers of the channel material 104 (or substantially monocrystalline layers, e.g., with a grain size of at least 5 nanometers, at least 20 nanometers, at least 50 nanometers, or at least 100 nanometers) and monocrystalline layers of the sacrificial material 402 (or substantially monocrystalline layers) may be grown over each other. In different embodiments, the channel material 104 and/or the sacrificial material 402 may be formed of any suitable single-crystal material, such as sapphire, quartz, silicon, a compound of silicon (e.g., silicon oxide), indium phosphide, germanium or a germanium alloy (e.g., silicon germanium), gallium, arsenic (e.g., an arsenide III compound, where arsenic III is in combination with another element such as boron, aluminum, gallium, or indium), or any group III-V material (i.e., materials from groups III and V of the periodic system of elements).

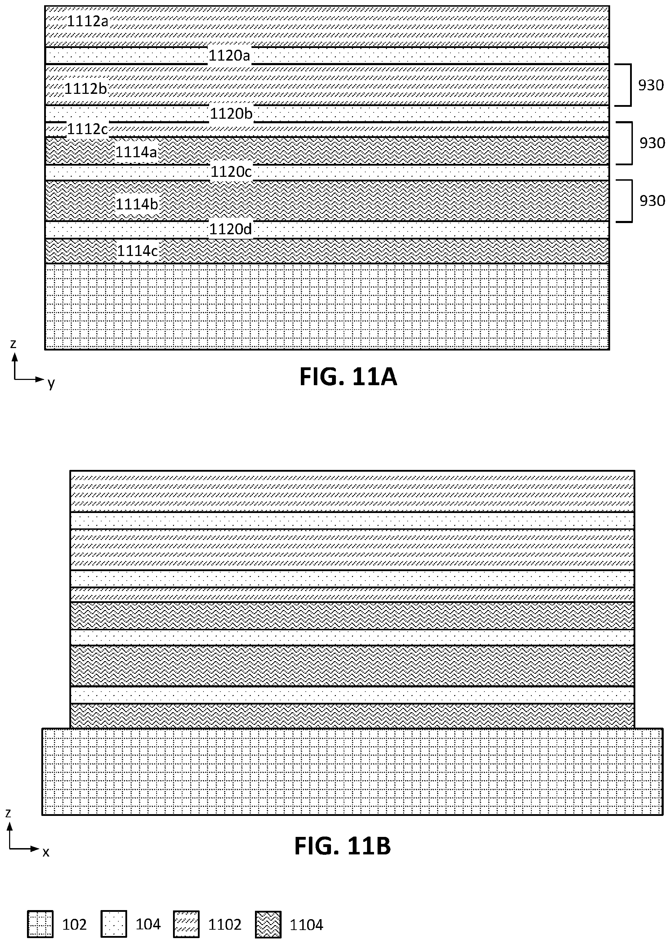

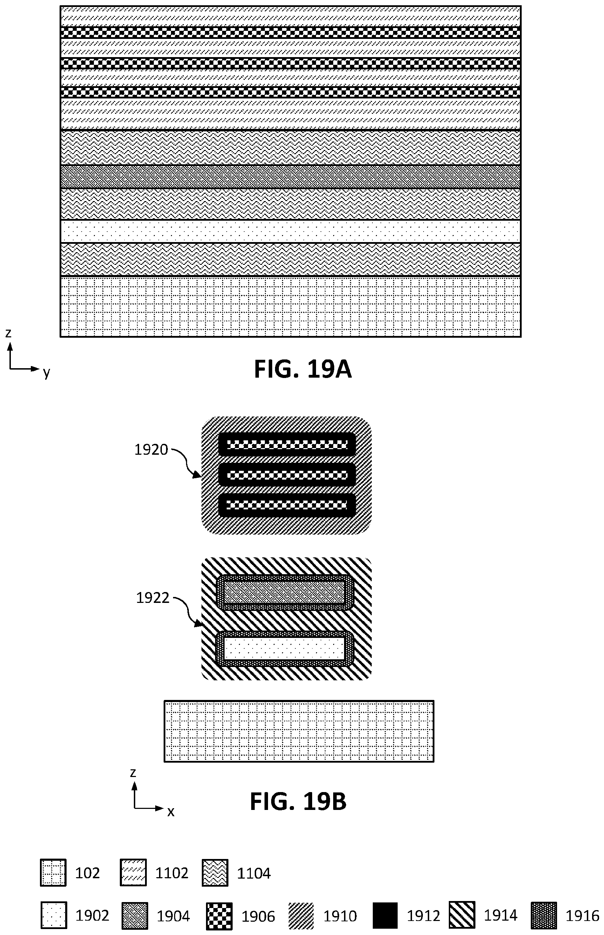

In the example of FIG. 4, two materials 104 and 402 are grown in layers over each other. In other examples, additional materials (e.g., two or more channel materials and/or two or more sacrificial materials) are used. An example with two different sacrificial materials is shown in FIGs. 11-18. An example with three different channel materials is illustrated in FIG. 19.

In some embodiments, one or more layers are not formed through a crystal growth process. For example, one or more layers of channel material may be deposited as thin films, e.g., a thin film of a high-mobility semiconductor material suitable for forming a channel region of a transistor. For example, a channel material 104 may have a higher carrier mobility (i.e., electron and/or hole mobility) than silicon. In various embodiments, the channel material 104, or certain layers of channel material, may include a high mobility oxide semiconductor material, such as tin oxide, antimony oxide, indium oxide, indium tin oxide (ITO), titanium oxide, zinc oxide, indium zinc oxide, indium gallium zinc oxide (IGZO), gallium oxide, titanium oxynitride, ruthenium oxide, tungsten oxide, or indium tungsten oxide. In other embodiments, the channel material 104 may include cobalt oxide, copper oxide (e.g., Cu₂O or CuO), ruthenium oxide, titanium oxynitride, nickel oxide, niobium oxide, copper peroxide, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphite, and black phosphorus. The channel material 104 may be doped with one or more of gallium, indium, aluminum, fluorine, boron, phosphorus, arsenic, nitrogen, tantalum, tungsten, and magnesium, etc.

In some embodiments, at least a portion of the layers of channel material and/or sacrificial material are layer transferred onto the support structure 102, or onto an initial set of layers of channel material and/or sacrificial material. For example, one or more layers (e.g., upper layers) of channel material 104 and sacrificial material 402 may be grown on a separate support structure and attached to a carrier wafer. These layers may be attached to a carrier wafer, or the separate support structure may be the carrier wafer. The layers are attached to the support structure 102 (e.g., over lower channel and sacrificial layers over the support structure 102), and the carrier wafer is removed, forming a full set of layers of channel material and sacrificial material 402. In this example, the upper layers may include a different channel material and/or sacrificial material 402 from the lower layers. An example is illustrated in FIG. 19.

Returning to FIG. 3, at 304, a process to etch the channel and sacrificial material to form individuated stacks of semiconductor regions is performed. FIGs. 5A and 5B illustrates the layers of the channel material 104 and sacrificial material 402 after stacks have been etched to form individuated channels for different transistor stacks. As shown in FIG. 4B, portions of the alternating layers are removed, leaving the stacks 510a, 510b, and 510c. The stack 510b includes semiconductor regions 520a, 520b, and 520c, which may correspond to the nanoribbons 220a, 220b, and 220c. The etching may be performed using a lithographic process, e.g., a mask may have been formed over the stacks 510a-510c so that the material under the masked regions is not removed. The stacks 510 are separated by etched regions 512a and 512b e.g., the etched region 512a is between the stacks 510a and 510b. FIG. 5A illustrates a cross-section through the stack 510b with the semiconductor regions 520a, 520b, and 520c.

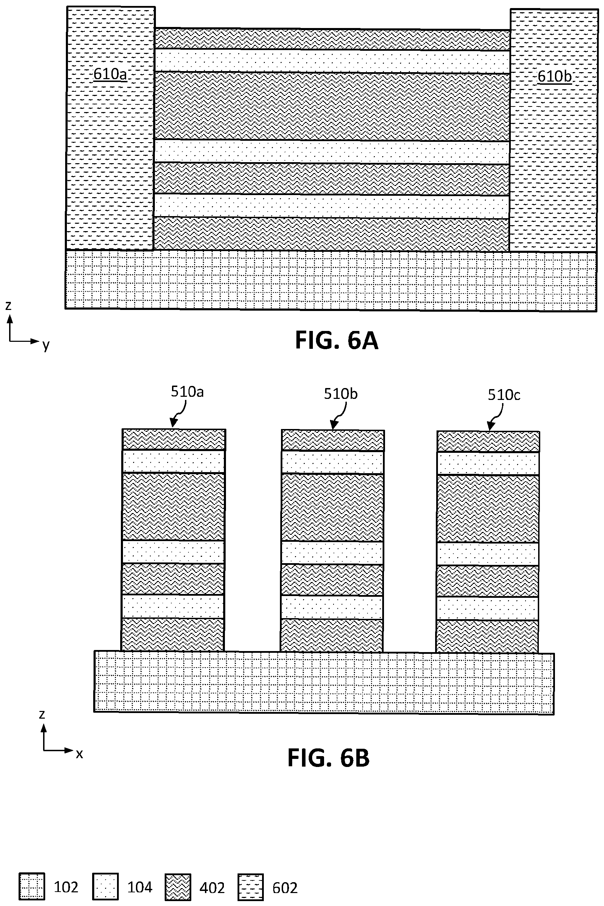

Returning to FIG. 3, at 306, a process to form anchors at opposite ends of the semiconductor regions is performed. FIGs. 6A and 6B illustrate formation of anchors 610a and 610b around the stacks of the layered channel material and sacrificial material. For example, at each end of the stacks 510 in the y-direction, a portion of the stack may be replaced with an anchor that provides physical support to the channel material 104 (e.g., the semiconductor regions 520a, 520b, and 520c) during later processing, e.g., when the sacrificial material 402 is removed. In some embodiments, the anchor material 602 is an S/D material, e.g., the material of the S/D regions 108, described above. In other embodiments, a temporary anchor material is used, and replaced at a later processing stage with the S/D region 108.

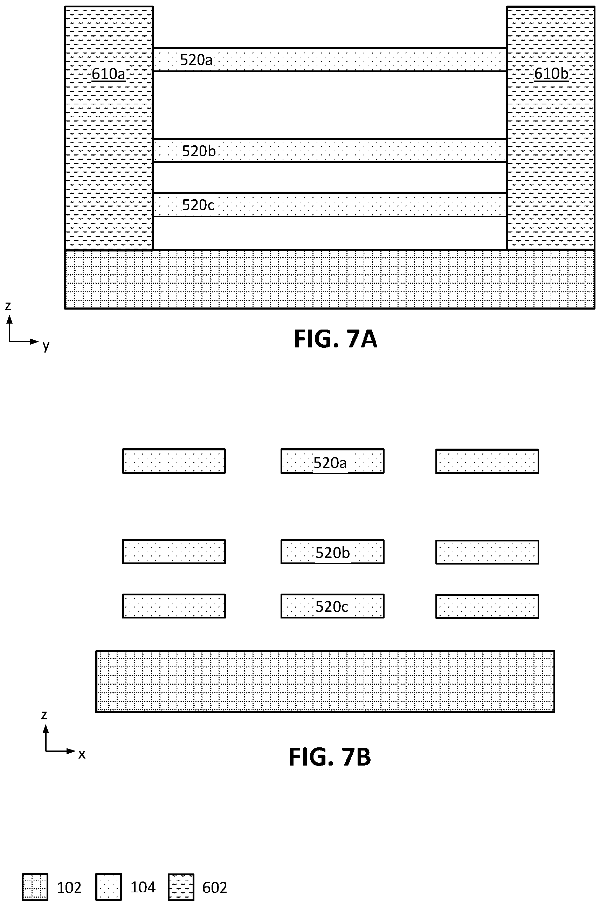

At 308, the sacrificial material is removed from the stacks. FIGs. 7A and 7B illustrate removal of the sacrificial material 402 from the stacks 510. In FIG. 7, the sacrificial material 402 has been etched, leaving the semiconductor regions (e.g., semiconductor regions 520a, 520b, and 520c) floating between the anchors 610, as illustrated in FIG. 7A. The sacrificial material 402 may be removed using an etching process, such as dry etch, wet etch, or a combination. An etchant material used to remove the sacrificial material 402 is selective to the sacrificial material 402, i.e., the etchant removes the sacrificial material 402 but does not remove the channel material 104 or the anchor material 602.

At 310, gate stacks are grown on the channel material, forming multiple independent gates for multiple stacked transistors. The gate stacks (e.g., gate dielectric and gate electrode) may be deposited using any suitable technique for conformally depositing materials, such as atomic layer deposition (ALD) or chemical vapor deposition (CVD). Conformal deposition generally refers to deposition of a certain coating on any exposed surface of a given structure. A conformal coating may, therefore, be understood as a coating that is applied to exposed surfaces of a given structure, and not, for example, just to the horizontal surfaces.

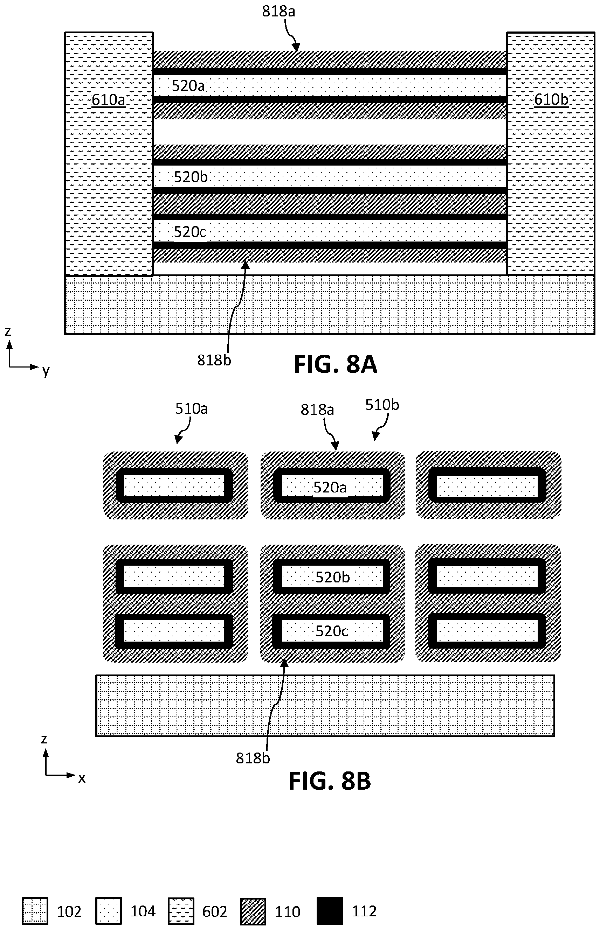

FIGs. 8A and 8B illustrate gate stacks deposited on the channels, around the channel material 104. For example, the gate stack 818a is around the uppermost semiconductor region 520a in the stack 510b. The gate stack 818b is around the lower two semiconductor regions 520b and 520c in the stack 510b. The gate stacks 818a and 818b include the gate dielectric 112 and the gate electrode 110. In the example shown in FIG. 8B, gate stacks around adjacent transistors in the x-direction (e.g., transistors in the stacks 510a and 510b) are physically isolated from each other. In this example, a front-side gate contact may be coupled to the gate stack 818a, while a back-side gate contact may be coupled to the gate stack 818b. In other example, adjacent gate stacks in the x-direction may be coupled together, forming a gate line, as shown in FIG. 9C, discussed below.

### Example stack of three transistors with two gate materials

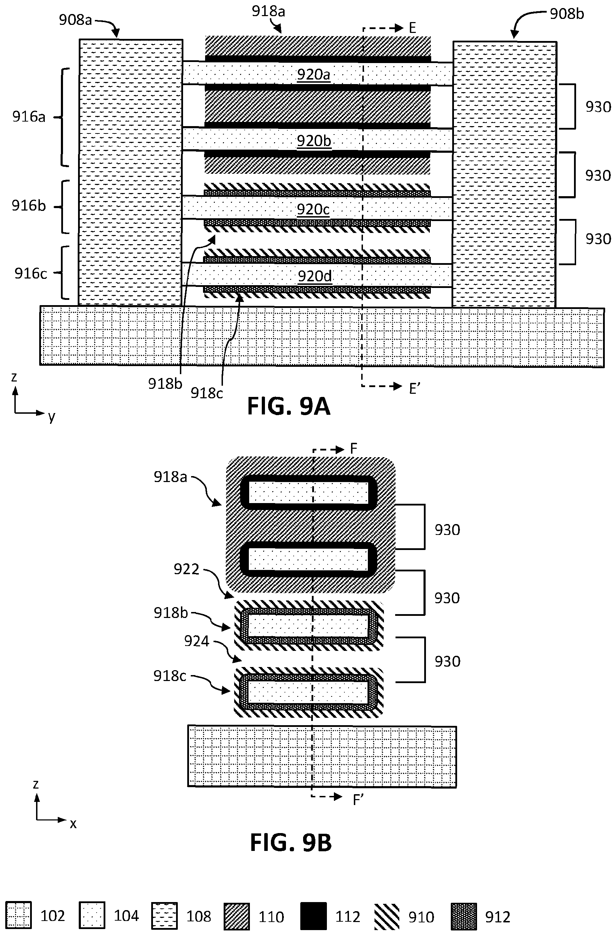

The example of FIGs. 2-8 included two stacked transistors with independent gates, where fabrication of the independent gates was enabled through the spacing of sacrificial materials between layers of the semiconductor channel material. As noted above, in other embodiments, three or more transistors may be included in the stack. Furthermore, in some embodiments, different gate materials (e.g., different gate dielectrics and/or different gate electrode materials) may be included in a stack of transistors. An example stack of three transistors that include two different gate materials is illustrated in FIG. 9.

FIG. 9A is a cross-section illustrating three stacked transistors formed around nanoribbons with different gate stacks, according to some embodiments of the present disclosure. FIG. 9B is a gate cross-section through the plane EE' in FIG. 9A. FIG. 9A illustrates the plane FF' in FIG. 9B.

Turning first to FIG. 9A, a stack of four semiconductor regions including the channel material 104 are over a support structure 102, which may be the support structure 102 described with respect to FIG. 1. In this example, the semiconductor regions are illustrated as nanoribbons 920a, 920b, 920c, and 920c. A first transistor 916a is formed over the two uppermost nanoribbons 920a and 920b. A second transistor 916b is formed around the nanoribbon 920c, and a third transistor is formed around the nanoribbon 920d.

The nanoribbons 920 are similar to the nanoribbons 220 described with respect to FIG. 2. As with the nanoribbons 220, each nanoribbon 920 is at a different height in the z-direction in the orientation shown in FIGs. 9A and 9B, i.e., a different distance from the support structure 102. Unlike in FIG. 2, in this example, the nanoribbons 920 are evenly spaced; a same distance 930 is between each pair of adjacent nanoribbons in the z-direction, i.e., between the nanoribbons 920a and 920b, between the nanoribbons 920b and 920c, and between the nanoribbons 920c and 920d. For example, a first distance between the nanoribbons 920a and 920b may be within 5%, 10%, 20%, 25%, 30% of a second distance between the nanoribbons 920b and 920c and/or of a third distance between the nanoribbons 920c and 920d, or within some other tolerance. While the distance 930 is depicted as being measured from the edges of the nanoribbons, alternatively the pitches (i.e., center-to-center distances) between nanoribbons 920 may be compared, and may be within any of the tolerances noted above, or some other tolerance. In other examples, the nanoribbons 920 may be unevenly spaced, e.g., as shown in FIG. 2.

A first S/D region 908a is at one end of the nanoribbons 920, and a second S/D region 908b is at the opposite end of the nanoribbons 920. The S/D regions 908 are similar to the S/D regions 208 of FIG. 2.

Central portions of the upper two nanoribbons 920a and 920b are surrounded by a gate stack 918a, which include the gate electrode 110 and the gate dielectric 112, also referred to as the first gate electrode 110 and first gate dielectric 112, respectively. The first gate dielectric 112 surrounds the nanoribbons 920a and 920b, and the gate electrode 110 surrounds the first gate dielectric 112. In the gate stack 918a, the first gate dielectric 112 and first gate electrode 110 span the height between the nanoribbons 920a and 920b, so that the first gate electrode 110 electrically couples the nanoribbons 920a and 920b.

Central portions of the nanoribbons 920c and 920d are surrounded by respective gate stacks 918b and 918c, which includes a second gate electrode 910 and a second gate dielectric 912. The second gate electrode 910 may include any of the materials described with respect to the gate electrode 110, and the second gate dielectric 912 may include any of the materials described with respect to the gate dielectric 112. The second gate dielectric 912 and first gate dielectric 112 may include different materials, and the second gate electrode 910 and first gate electrode 110 may include different materials. The second gate dielectric 912 surrounds each of the nanoribbons 920c and 920d, and the second gate electrode 910 surrounds the second gate dielectric 912. The gate stacks 918b is electrically and physically isolated from the gate stack 918a and the gate stack 918c. As illustrated in FIG. 9B, a gap 922 is between the gate stack 918a and gate stack 918b, and a gap 924 is between the gate stack 918b and gate stack 918c. These gaps 922 and 924 may be filled in with a dielectric material, e.g., the dielectric material 106 described with respect to FIG. 1. More generally, while not specifically, shown, regions of the device outside of the nanoribbons 920, gate stacks 918, and S/D regions 908 may be filled in with a dielectric material, e.g., the dielectric material 106.

The second gate dielectric 912 and first gate dielectric 112 may include different materials. For example, different dielectric materials may have different dielectric constants. For example, using different dielectric materials may result in different threshold voltages (e.g., a higher dielectric constant may cause a transistor to have a higher threshold voltage), so that different transistors in the stack have different threshold voltages. As another example, the selection of the dielectric material may change the gate-induced drain leakage. If the first gate electrode 110 and second gate electrode 910 are different, the materials for the second gate dielectric 912 and first gate dielectric 112 may be selected in conjunction with the materials for the first gate electrode 110 and second gate electrode 910, e.g., based on material compatibility, processing compatibility, gate capacitance, stability, and other factors.

Furthermore, different dielectric materials may be selected based on interactions between particular gate dielectrics and channel materials. For example, if a subset of the nanoribbons 920 (e.g., nanoribbons 920a and 920b) include oxygen (e.g., IGZO or another thin film material described above), and another portion of the nanoribbons 920 (e.g., nanoribbons 920c and 920d) do not include oxygen (e.g., monocrystalline silicon or germanium), the dielectric around the oxygen-containing channel materials may be selected to include certain materials, such as rubidium or molybdenum, that do not interact with the oxygen in the channel, whereas the dielectric around the channel material that has superior electrical properties but may interact with an oxygen-containing channel (e.g., titanium).

In some embodiments, the layers of the different dielectrics 912 and 112 may have different thicknesses, e.g., the first gate dielectric 112 is thicker than second gate dielectric 912. In some cases, the second gate dielectric 912 and first gate dielectric 112 may include the same material (e.g., silicon oxide, hafnium oxide, etc.) and are deposited with different thicknesses. Different thickness of the layers of the dielectrics 912 and 112 may also result in different threshold voltage and/or different amounts of gate-induced drain leakage.

Furthermore, the second gate electrode 910 and first gate electrode 110 may include different materials. As noted above, the materials for the second gate electrode 910 and first gate electrode 110 may be chosen in conjunction with the materials for the second gate dielectric 912 and first gate dielectric 112. In various embodiments, a stack of transistors includes two or more different gate dielectric materials and a single gate electrode material used across the stack; two or more gate electrode materials and a single gate dielectric material used across the stack; two or more different gate electrode materials and two or more different gate dielectric materials; or other various combinations of gate electrode materials and gate dielectric materials. The materials for the first and second gate electrodes 110 and 910 may include different metals, different combinations of metals and/or non-metals, different relative concentrations of materials, etc. In some embodiments, using different electrode materials may provide different work functions at different transistors, which may result in different threshold voltages for different transistors. As another example, using different electrode materials may provide different levels of gate capacitance, which can affect switching speed and power consumption for different transistors.

In FIG. 9A, the gate electrodes around the different transistors 916a, 916b, and 916c are physically and electrically isolated from each other. Thus, an individual nanoribbon (e.g., nanoribbon 920c and 920d) may have its own independent gate stack (e.g., the gate stack 918b or 918c, respectively), or a subset of the nanoribbons (e.g., the nanoribbons 920a and 920b, which are adjacent to each other in the stack of nanoribbons) may be jointly controlled by a gate stack (e.g., the gate stack 918a). This may result in transistors with different strengths, as discussed above.

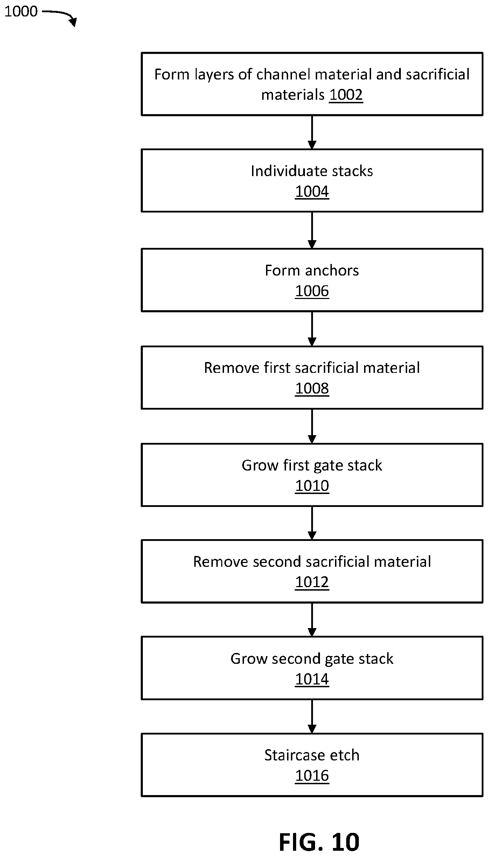

In the example of FIGs. 2-8, to obtain independent gate stacks, the nanoribbons 220a and 220b were spaced relatively far apart from each other. In this example, adjacent nanoribbons 920 are evenly spaced by a distance 930, as noted above. To form multiple independent transistors that are vertically stacked, different sacrificial materials may be used around different portions of the nanoribbon stack. In particular, during fabrication, a first sacrificial material may be above, below, and between the nanoribbons 920a and 920b, while a second sacrificial material may be above, below, and between the nanoribbons 920c and 920d. The sacrificial materials may be selectively removed and replaced with the gate stacks 918, enabling fabrication of the gate stack 918a at a separate time and in a separate subprocess from fabrication of the gate stacks 918b and 918c. An example fabrication process is illustrated in FIGs. 10-18.

FIG. 9B is a gate cross-section through the plane EE' in FIG. 9A. FIG. 9B illustrates a single stack of transistors, i.e., the transistors 916a, 916b, and 916c. As noted above, the gate stacks 918a, 918b, and 918c are not connected and are electrically isolated. In some embodiments, transistors at different positions in the x-direction are coupled together at their gate stacks, e.g., as shown in FIG. 9C.

FIG. 9C is an expanded gate cross-section through the plane EE' in FIG. 9A, according to some embodiments of the present disclosure. In the x-z cross-section illustrated in FIG. 9C, transistors in different stacks 900a, 900b, and 900c are physically and electrically connected in the horizontal direction by gate lines 940a, 940c, and 940c. For example, if the transistor stack 900b corresponds to the transistors 916a, 916b, and 916c shown in FIGs. 9B and 9C, the gate stack 918a around the upper nanoribbons 920a and 920b is electrically and physically coupled to similar gate stacks around the upper two nanoribbons in the stack 900a (to the right of the stack 900b) and the upper nanoribbon in the stack 900c (to the left of the stack 900b). These connected gate stacks form a gate line 940a. Similar gate lines 940b and 940c are along the lower two nanoribbon channels in the stacks 900, but each of the gate lines 940b and 940c is coupled to a single nanoribbon in each stack. The gate lines 940 extend in a direction perpendicular to the length of the nanoribbons 920. In this example, the nanoribbons 920 and, more generally, the individual transistors extend from their first end (i.e., the S/D region 908a) to their second end (i.e., the S/D region 908b) along the y-direction, while the gate lines 940 extend in the x-direction.

The spacing of the nanoribbons within each stack 900 and between adjacent stacks 900, along with the selected deposition process parameters, may enable the formation of horizontal gate lines. For example, the horizontal distance 942 between adjacent nanoribbons in the x-direction may be less than the vertical distance 930 (shown in FIGs. 9A and 9B) between nanoribbons 920 in the z-direction.

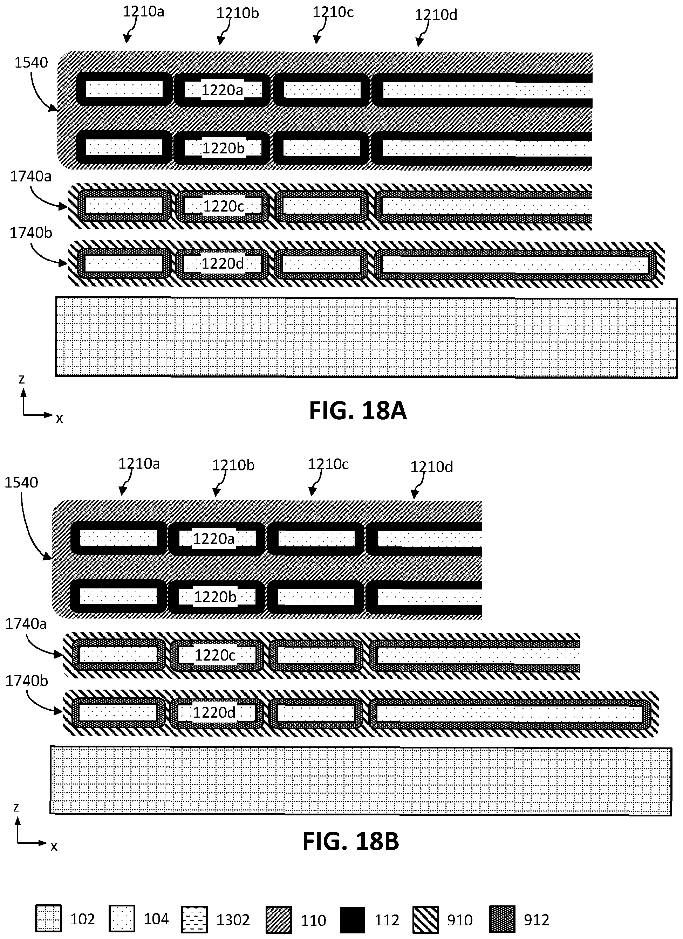

The gate lines 940 enable independent electrical connections to the gate of each transistor in a given stack 900. The gate lines 940 be formed by extending the gate materials (e.g., the gate electrodes 110 and 910) in the x-direction in the coordinate shown to different lengths at different heights along the stacks 900, so that the ends of the gate electrodes 110 and 910 resemble a staircase. Vias 950 at different positions in the x-direction can then connect to the different gate lines 940 or different "steps" of the staircase. In some embodiments, the extension regions may further include the channel material 104 and gate dielectrics 112 and 912, as illustrated in FIG. 18.

Each of the transistors (e.g., transistors 916a, 916b, and 916c) in the stacks 900 (e.g., the stack 900b) may be considered to be in a separate layer (e.g., a separate transistor layer) of the device, and the extension regions for forming the gate line-via connections extends along the transistor layer. Each extension region is coupled to a respective gate via 950, and each of the gate vias 950 extends down from a front side of the device. The gate via 950a is coupled to the top transistor layer, and in particular, to the extension region of the gate line 940a. Each subsequent gate via 940b and 940c is coupled to the next gate line in a lower transistor layer. For example, the gate via 940c extends through the upper two transistor layers. The gate vias 950 may have different lengths, i.e., heights in the z-direction. For example, the gate via 950a has a shorter height, also referred to as shorter length, than the gate via 950c. The vias 950 may be formed from any conductive material 914, such as copper or another metal. In some embodiments, the vias 950 include multiple layers, e.g., one or more liner layers and a fill layer.

### Example process for fabricating stacked transistors with different gate stacks

FIG. 10 is a flow diagram of a process 1000 for fabricating stacked transistors with different independent gate stacks formed around nanoribbons, according to some embodiments of the present disclosure. FIGs. 11-18 illustrate various steps in the processing method 1000 of FIG. 10, according to some embodiments of the present disclosure. In general, the processing method 1000 is performed across a wafer, with many individual stacks of transistors (or stacks of memory devices including the stacks of transistors) formed on the wafer. FIGs. 11-18 illustrate cross-sections of processing steps across several stacks of transistors. Additional steps may be performed before, during, and/or after the process 1000 to produce a device that includes the stacked transistors with different independent gates.

At 1002, a process for forming layers of a channel material and sacrificial materials is performed. To produce a stack of GAA transistors with independent gates and different gate stacks, the channel material may be formed in layers, in a stack that also includes at least two different sacrificial materials. The arrangement of the channel material and the sacrificial materials may be selected so that different gate stacks may be deposited around different nanoribbons, as described with respect to FIG. 9 and illustrated in FIGs. 11-18.

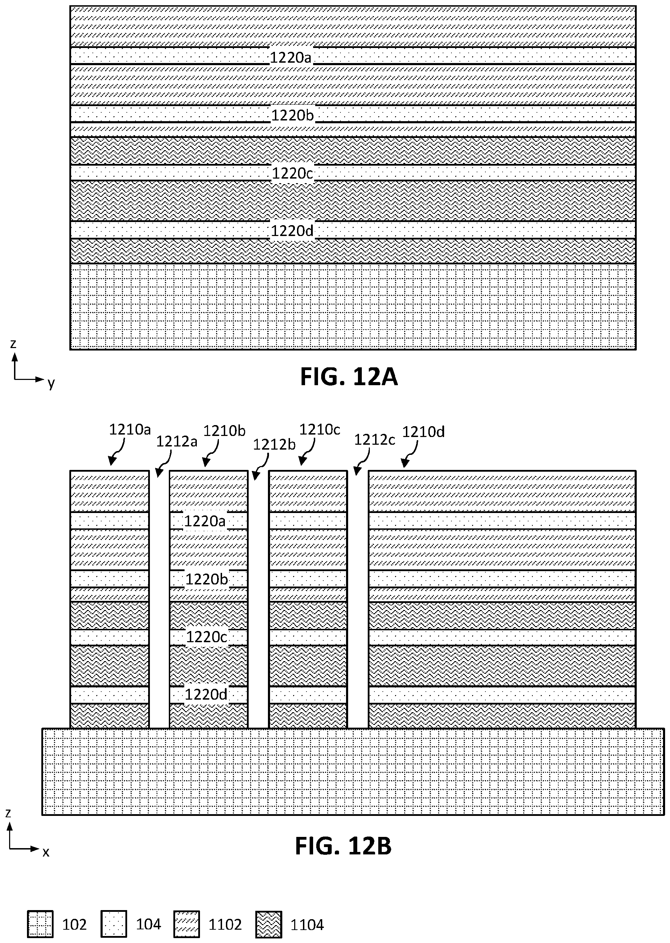

FIGs. 11A and 11B are two perpendicular cross-sections illustrating layers of a channel material and two sacrificial materials, according to some embodiments of the present disclosure. FIG. 11A is a cross-section in the y-z plane, and FIG. 11B is a cross-section in the x-z plane. FIGs. 12-17 illustrate the same two cross-sections at different stages of the processing method.

FIGs. 11A and 11B illustrate four layers 1120a-1120d of the channel material 104 interspersed with layers 1112a-1112c of a first sacrificial material 1102 and layers 1114a-1114c of a second sacrificial material 1104. In this example, four layers of the channel material 104 are illustrated; in other examples, fewer or additional layers may be included. A layer 1114c of the second sacrificial material 1104 is over the support structure 102, followed by a layer 1120d of the channel material 104, followed by another layer 1114b of the second sacrificial material 1104, followed by another layer 1120c of the channel material 104, and so forth, with the sacrificial material changing to the first sacrificial material 1102 over the layer 1114a of the second sacrificial material 1104. The upper layers 1120a and 1120b of the channel material 104 are surrounded by first sacrificial material 1102, while the lower layers 1120c and 1120c of the channel material 104 are surrounded by the second sacrificial material 1104.

In this example, the first sacrificial material 1102 and second sacrificial material 1104 are arranged so that the layers 1120 of the channel material 104 are evenly spaced, with the distance 930 between pairs of adjacent layers 1120. While a single channel material 104 is illustrated in FIGs. 11-18, in other examples, two or more channel materials may be included in a stack of transistors, e.g., as shown in FIG. 19.

The channel material 104, first sacrificial material 1102, and second sacrificial material 1104 include different materials. For example, the channel material 104 is silicon, the first sacrificial material 1102 includes a mixture of silicon and germanium, and the second sacrificial material 1104 includes germanium. In another example, the first and second sacrificial materials 1102 and 1104 both include silicon and germanium, but have different relative concentrations of silicon and germanium. If a crystal growth process is used to form the layers shown in FIG. 11, the sacrificial materials 1102 and 1104 may be chosen to have a similar crystal structure to the channel material 104, so that monocrystalline layers of the channel material 104 (or substantially monocrystalline layers, e.g., with a grain size of at least 5 nanometers, at least 20 nanometers, at least 50 nanometers, or at least 100 nanometers), monocrystalline layers of the first sacrificial material 1102 (or substantially monocrystalline layers), and monocrystalline layers of the second sacrificial material 1104 (or substantially monocrystalline layers) may be formed over each other. In different embodiments, the channel material 104 and/or the sacrificial materials 1102 and 1104 may be formed of any suitable single-crystal material, such as sapphire, quartz, silicon, a compound of silicon (e.g., silicon oxide), indium phosphide, germanium or a germanium alloy (e.g., silicon germanium), gallium, arsenic (e.g., an arsenide III compound, where arsenic III is in combination with another element such as boron, aluminum, gallium, or indium), or any group III-V material (i.e., materials from groups III and V of the periodic system of elements).

In other embodiments, at least a portion of the layers may be formed using a different method, such as deposition of non-crystalline materials (e.g., thin film deposition), or at least a portion of the layers may be transferred over the support structure 102 or onto another portion of the layers, as described above. For example, the layers 1112 of the first sacrificial material 1102 and the upper layers 1120a and 1120b of the channel material may be layer-transferred onto the upper surface of the layer 1114a of the second sacrificial material 1104.

Returning to FIG. 10, at 1004, a process to etch the channel and sacrificial materials to form individuated stacks of semiconductor regions is performed. FIG. 12 illustrates the layers of the channel material 104 and sacrificial materials 1102 and 1104 after stacks have been etched to form individuated channels for different transistor stacks. As shown in FIG. 12B, portions of the alternating layers are removed, leaving the stacks 1210a, 1210b, 1210c, and 1210d. The stack 1210b includes semiconductor regions 1220a, 1220b, 1220c, and 1220c which may correspond to the nanoribbons 920a, 920b, 920c, and 920d. The etching may be performed using a lithographic process, e.g., a mask may have been formed over the stacks 1210 so that the material under the masked regions is not removed. The stacks 1210 are separated by etched regions 1212a, 1212b, and 1212c, e.g., the etched region 1212a is between the stacks 1210a and 1210b. FIG. 12A illustrates a cross-section through the stack 1210b.

The stacks 1210 are fairly close together, i.e., the etched regions 1212 are relatively narrow in the x-direction, so that the gate electrodes 110 and 910 can close the gaps between the nanoribbons, as shown in FIG. 9C and illustrated further below. The stack 1210d is wider in the x-direction than the other stacks; while the stacks 1210a-1210c may be used to form transistors, the stack 1210d may be used to form gate extension regions, as described further below.

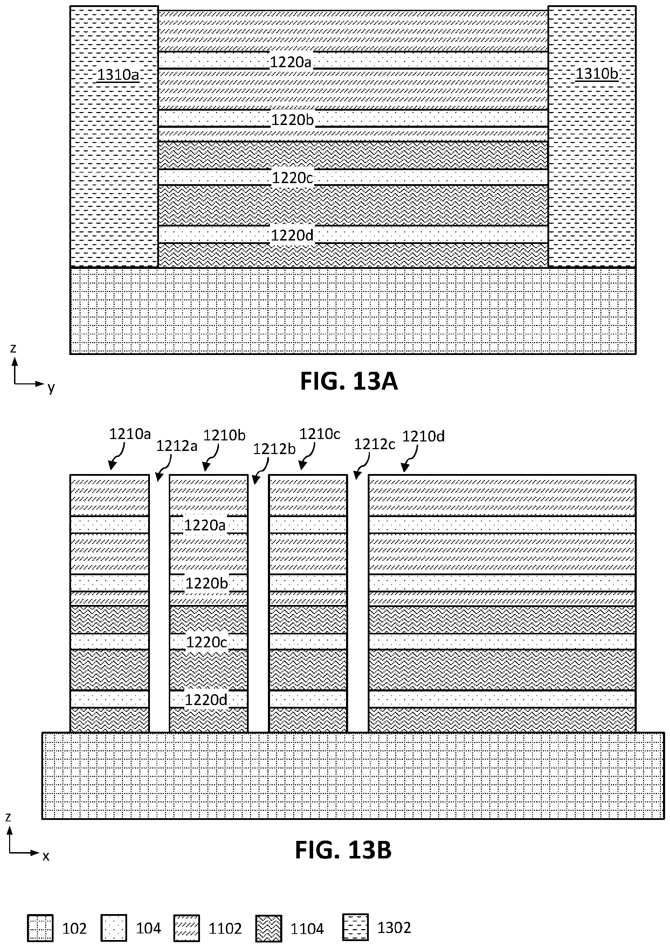

Returning to FIG. 10, at 1006, a process to form anchors at opposite ends of the semiconductor regions is performed. FIGs. 13A and 13B illustrate formation of anchors 1310a and 1310b around the stacks of the layered channel material and sacrificial materials. For example, at each end of the stacks 1210 in the y-direction, a portion of the stack may be replaced with an anchor that provides physical support to the channel material 104 (e.g., the semiconductor regions 1220a, 1220b, 1220c, and 1220d) during later processing, e.g., when the sacrificial materials 1102 and 1104 are removed. In some embodiments, the anchor material 1302 is an S/D material, e.g., the material of the S/D regions 108, described above. In other embodiments, a temporary anchor material is used, and replaced at a later processing stage with the S/D region 108.

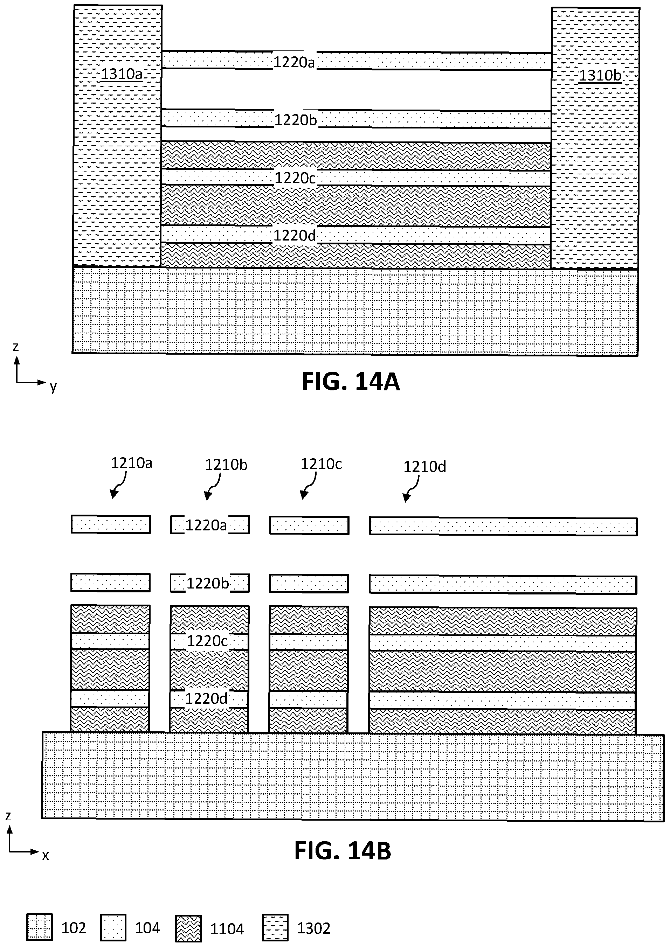

At 1008, the first sacrificial material is removed from the stacks. FIGs. 14A and 14B illustrate removal of the first sacrificial material 1102 from the stacks 1210. In FIG. 14, the first sacrificial material 1102 has been etched, leaving the upper two semiconductor regions (e.g., semiconductor regions 1220a and 1220b) floating between the anchors 1310, as illustrated in FIG. 14A. The lower semiconductor regions (e.g., the regions 1220c and 1220d) are still surrounded by the second sacrificial material 1104 (and, on their ends, the anchors 1310). The first sacrificial material 1102 may be removed using an etching process, such as dry etch, wet etch, or a combination. An etchant material used to remove the first sacrificial material 1102 is selective to the first sacrificial material 1102, i.e., the etchant removes the first sacrificial material 1102 but does not remove the channel material 104, the second sacrificial material 1104, or the anchor material 1302.

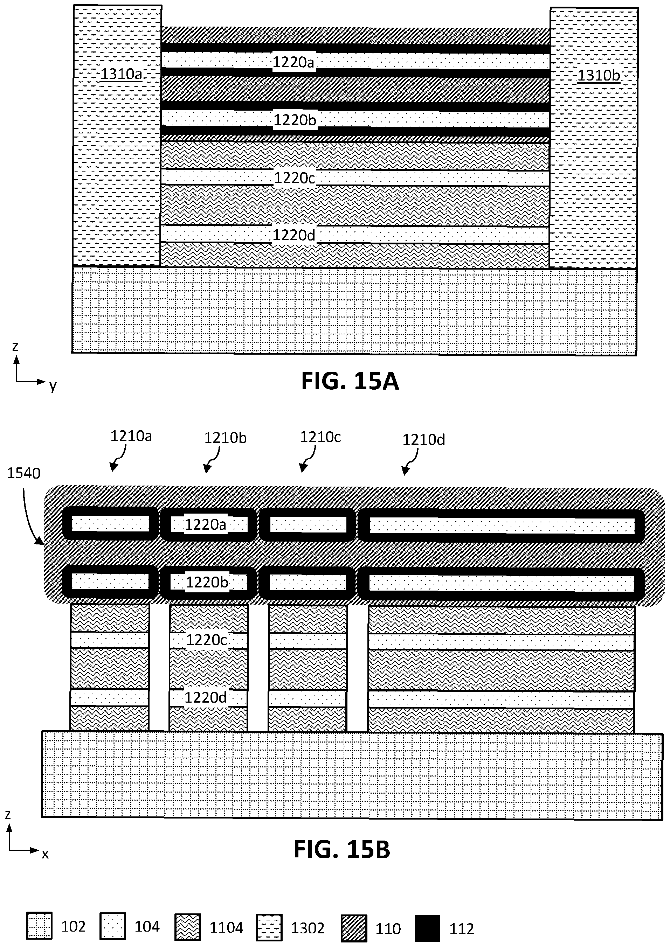

At 1010, first gate stacks are grown on the channel material, forming a first gate stack. The gate stack (e.g., gate dielectric and gate electrode) may be deposited using any suitable technique for conformally depositing materials, such as ALD or CVD. FIGs. 15A and 15B illustrate gate stacks deposited on the upper semiconductor regions, e.g., the semiconductor regions 1220a and 1220b. For example, a gate stack that includes the first gate dielectric 112 and the first gate electrode 110 is around the uppermost semiconductor regions 1220a and 1220b in the stacks 1210b. A similar gate stack is also around the uppermost two semiconductor regions in the other stacks 1210a, 1210c, and 1210d, forming a gate line 1540, which is similar to the gate line 940a.

The bottom of the gate line 1540 (i.e., the lowest surface of the first gate electrode 110, i.e., the surface of the first gate electrode 110 nearest to the support structure 102) is along an upper surface of the second sacrificial material 1104. The second sacrificial material 1104 blocks the gate electrode 110 from growing in the lower portion of the stack, so that the gate electrode 110 is only deposited around the upper semiconductor regions 1220 of the stacks 1210.

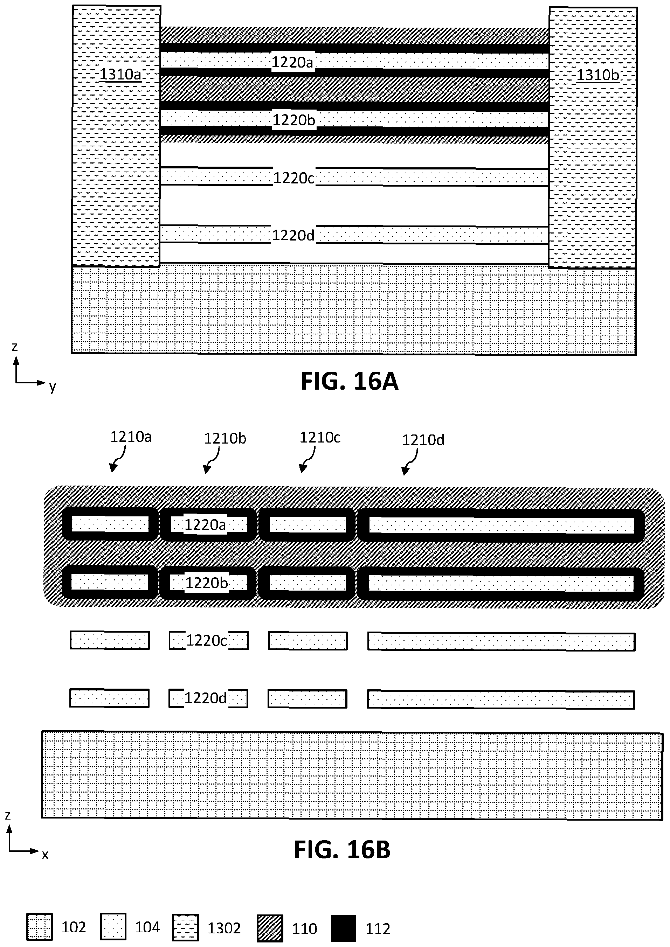

At 1012, the second sacrificial material is removed from the stacks. FIGs. 16A and 16B illustrate removal of the second sacrificial material 1104 from the stacks 1210. In FIG. 16, the second sacrificial material 1104, leaving the lower two semiconductor regions (e.g., semiconductor regions 1220c and 1220d) floating between the anchors 1310, as illustrated in FIG. 16A. The upper semiconductor regions are still surrounded by the gate stacks (and, on their ends, the anchors 1310). The second sacrificial material 1104 may be removed using an etching process, such as dry etch, wet etch, or a combination. An etchant material used to remove the second sacrificial material 1104 is selective to the second sacrificial material 1104, i.e., the etchant removes the second sacrificial material 1104 but does not remove the channel material 104, the first gate electrode 110, or the anchor material 1302.

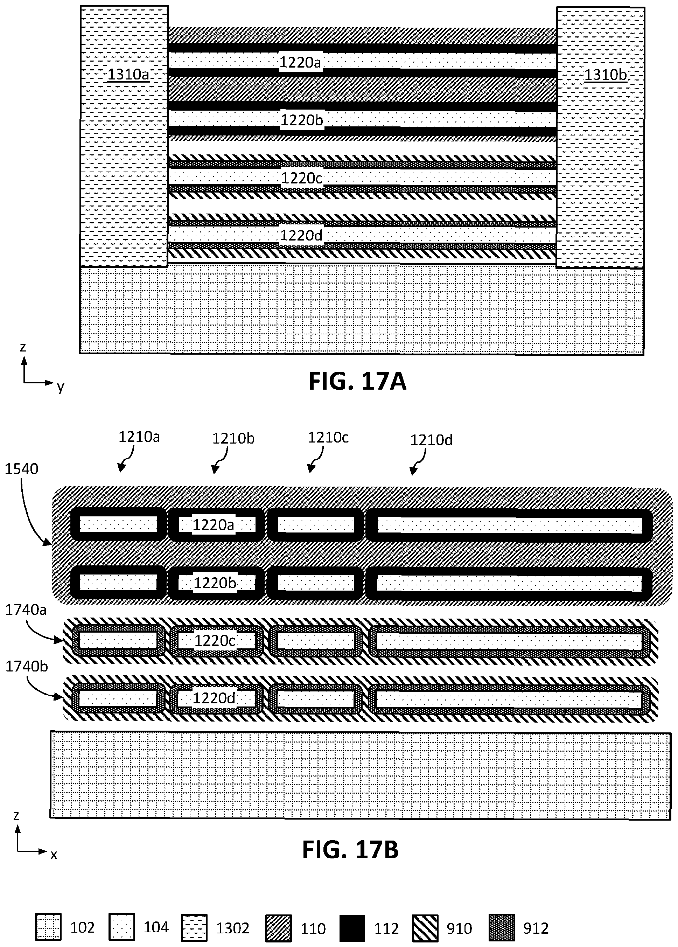

At 1014, second gate stacks are grown on the channel material, forming a second gate stack. The second gate stack (e.g., second gate dielectric 912 and second gate electrode 910) may be deposited using any suitable technique for conformally depositing materials, such as ALD or CVD. FIGs. 17A and 17B illustrate gate stacks deposited on the lower semiconductor regions, e.g., the semiconductor regions 1220c and 1220d. For example, a gate stack that includes the second gate dielectric 912 and the second gate electrode 910 is around the semiconductor region 1220c, and another gate stack that includes the second gate dielectric 912 and the second gate electrode 910 is around the semiconductor region 1220d. Similar gate stacks are also around the lower two semiconductor regions in the other stacks 1210a, 1210c, and 1210d, forming gate lines 1740a and 1740b, which are similar to the gate lines 940b and 940c, respectively. The gate lines 1740a is physically separated and electrically isolated from the adjacent gate lines 1540 and 1740b. To achieve independent gate lines around the lower two semiconductor regions 1220c and 1220d and a single gate line around the upper two semiconductor regions 1220a and 1220b, the upper gate stack with the first gate electrode 110 and first gate dielectric 112 may be relatively thick compared to the lower gate stacks with the second gate electrode 910 and second gate dielectric 912. For example, the gate electrode 110 is deposited thick enough to span the distance 930 between the semiconductor region 1220a and semiconductor region 1220b, while the second gate electrode 910 is deposited thin enough such that it does not span the distance to the gate electrode 110, or such that the second gate electrode 910 does not span the distance 930 between the semiconductor region 1220c and semiconductor region 1220d.

While FIG. 10 and FIGs. 13-17 illustrate the first sacrificial material 1102 being replaced by a first gate stack, followed by the second sacrificial material 1104 being replaced by a second gate stack, in other embodiments, the order is reversed, with the second sacrificial material 1104 being removed and replaced with a gate stack prior to the first sacrificial material 1102 being removed and replaced with a gate stack.

At 1016, a staircase etch process is performed to enable connections to the individual gate lines, e.g., the gate vias 950 shown in FIG. 9. FIGs. 18A and 18B illustrate two steps in forming a staircase structure for the gate vias, according to some embodiments of the present disclosure. FIG. 18A and 18B both illustrate cross-sections in the x-z plane, e.g., the view shown in FIG. 17B. A multi-step lithographic process may be used to form the gate extension regions. The transistors, e.g., the stacks 1210a, 1210b, and 1210c, may generally be masked during this process. The channel material 104 and/or gate dielectrics 112 and 912 in the extension region (i.e., in the stack 1210d) may be removed or may remain in place, as shown in FIG. 18. In addition, the right-most portions of the gate lines 1540 and 1740a in the region of the stack 1210d are removed, as shown in FIG. 14A. This leaves the right-most portion of the gate line 1740b exposed, so that a via (e.g., the via 950c of FIG. 9C) can be formed over the gate line 1740b.

After exposing the gate line 1740b, the right-most remaining portions of the gate lines 1540 in the region of the stack 1210d are removed, as shown in FIG. 18B. This leaves the right-most remaining portion of the gate line 1740a exposed, so that a via (e.g., the via 950b of FIG. 9C) can be formed over the gate line 1740a. A via (e.g., the via 950a of FIG. 9C) may also be formed over the remaining portion of the gate line 1540.

### Example variations of stacked transistors

While in the examples of FIGs. 2-18, the same channel material was used in multiple transistors, in some embodiments, different channel materials may be used within different transistors in a given stack, or different channel materials may be used within a single transistor. While in the examples of FIGs. 2-18, each transistor in a given stack included one or two semiconductor regions, a transistor may include three, four, five, or more semiconductor regions. The semiconductor regions may have various shapes, e.g., different thicknesses, and may be coupled to different gate materials.

FIG. 19 illustrates an example fabrication template and an example cross-section of a pair of vertically stacked transistors with variation between the number, material, and arrangement of semiconductor regions. FIG. 19A is an example stack of materials for forming stacked transistors with different channel materials and different gate stacks, and FIG. 19B is an example gate cross-section of stacked transistors with different channel materials and different gate stacks formed from the stack shown in FIG. 19A.

Turning first to FIG. 19A, an initial material stack of semiconductor materials and sacrificial materials for fabricating vertically stacked transistors includes three channel materials 1902, 1904, and 1906. Each of the channel materials 1902, 1904, and 1906 may be a different one of the channel materials 104, described above. For example, different channel materials may include different elements (e.g., the channel material 1902 includes silicon, the channel material 1904 includes germanium, and the channel material 1906 includes one of the thin film semiconductors described above), different concentrations of elements (e.g., the channel materials 1902 and 1904 include different relative concentrations of silicon and germanium), and/or different material structures (e.g., the channel materials 1902 and 1904 are monocrystalline, while the channel material 1906 is polymorphous or amorphous). Layers of the channel materials 1902, 1904, and/or 1906 may have different thicknesses, e.g., in FIG. 19, the channel materials 1902 and 1904 are thicker in the z-direction than the channel material 1906. While the channel materials 1902 and 1904 are depicted as having the same thickness, in other embodiments, the channel materials 1902 and 1904 may have different thicknesses.

The material stack in FIG. 19A further includes the first sacrificial material 1102 and second sacrificial material 1104. The material stack may be fabricated using any of the techniques described above, e.g., a growth, deposition, or layer transfer process, or a combination of processes. For example, the first sacrificial material 1102, first channel material 1902, and second channel material 1904 may be a set of materials compatible for crystal growth. The second sacrificial material 1104 and third channel material 1906 may be deposited as thin films over the uppermost layer of the first sacrificial material 1102, or layer transferred over the uppermost layer of the first sacrificial material 1102.

FIG. 19B illustrates different gate stacks formed around the channel materials 1902, 1904, and 1906. The gate stacks may be formed by removing the first sacrificial material 1102, depositing a first gate dielectric 1912 and a first gate electrode 1910 around semiconductor regions (e.g., nanoribbons) of the first and second channel materials 1902 and 1904, removing the second sacrificial material 1104, and depositing a second gate dielectric 1916 and a second gate electrode 1914 around semiconductor regions (e.g., nanoribbons) of the third channel material 1906. Alternatively, the second sacrificial material 1104 may be removed and replaced by the second gate dielectric 1916 and a second gate electrode 1914 prior to removing the first sacrificial material 1102 and depositing the first gate dielectric 1912 and a first gate electrode 1910. Individuated stacks of nanoribbons may be formed as described with respect to FIGs. 3 and 10.

In the example of FIG. 19B, the upper transistor in the stack includes three semiconductor regions of the channel material 1906. The lower transistor in the stack includes two semiconductor regions with different channel materials, i.e., the lower transistor includes one semiconductor region formed from the channel material 1902, and another semiconductor region formed from the channel material 1904. Using two different channel materials in the transistor can result in a transistor that has two power modes. A lower threshold voltage may cause current to flow across a first semiconductor region or first set of semiconductor regions (e.g., the region comprising the channel material 1902), while a higher threshold voltage may cause current to flow across one or more additional semiconductor regions (e.g., both the region comprising the channel material 1902 and the region comprising the channel material 1904).

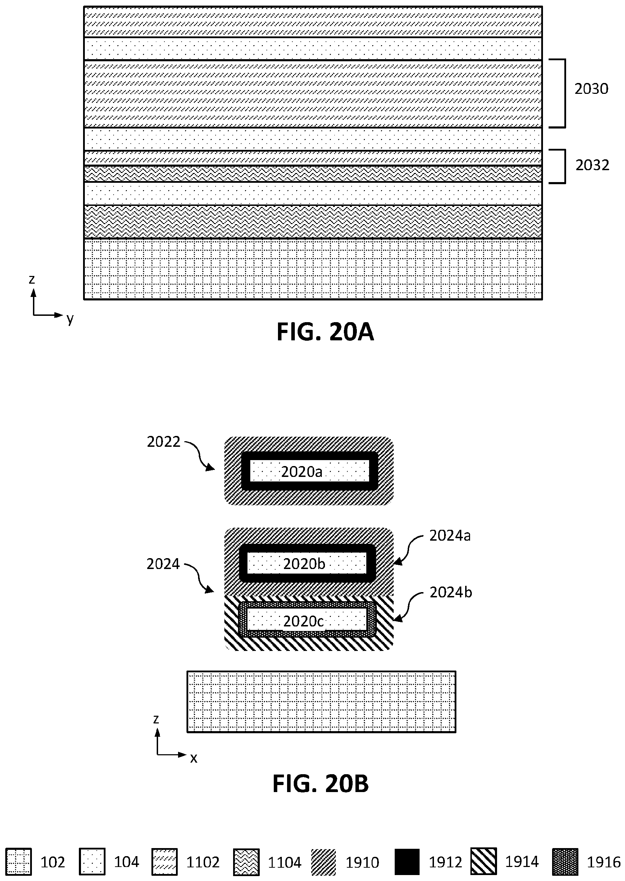

FIG. 20 illustrates an example fabrication template and an example cross-section of a pair of vertically stacked transistors where a transistor includes multiple gate materials. FIG. 20A is an example stack of materials for forming stacked transistors with different gate materials in a single transistor, and FIG. 20B is an example gate cross-section of stacked transistors with different gate materials in a single transistor formed from the stack shown in FIG. 20A.

Turning first to FIG. 20A, an initial material stack of semiconductor materials and sacrificial materials for fabricating vertically stacked transistors includes the channel material 104. In other embodiments, two or more different channel materials may be included in the initial material stack (e.g., the channel materials 1902, 1904, and/or 1906). More or fewer layers of the channel material 104 or other channel materials may be included, based on the number of transistors and number of semiconductor regions within each transistor to be included. Furthermore, while the layers of the channel material 104 are depicted as having the same thicknesses in the z-direction, in other embodiments, the layers of the channel material 104 may have different thicknesses.

The material stack in FIG. 20A further includes the first sacrificial material 1102 and second sacrificial material 1104, discussed above. In this example, the distance 2030 between the upper and middle channel material layers is similar to the distance 230 of FIG. 2, and the distance 2032 between the lower and middle channel material layers is similar to the distance 232 of FIG. 2. The stack includes relatively thin layers of the first sacrificial material 1102 and 1104 between the lower and middle channel layers (i.e., the two layers together have the thickness 2032), and a relatively thick layer of the first sacrificial material 1102 (i.e., with the thickness 2030, which is greater than the thickness 2032). The material stack may be fabricated using any of the techniques described above, e.g., a growth, deposition, or layer transfer process, or a combination of processes.

FIG. 20B illustrates different gate stacks formed around an individuated stack of the channel material 104, which includes the semiconductor regions 2020a, 2020b, and 2020c, which are similar to the nanoribbons 220. A first gate stack 2022 is around the upper semiconductor region 2020a, and a second gate stack 2024 is around the lower two semiconductor regions 2020b and 2020c. The second gate stack 2024 includes a first portion 2024a around the semiconductor region 2020b and a second portion 2024b around the semiconductor region 2020c. The two portions 2024a and 2024b are in physical and electrical contact with each other.

The first gate stack 2022 and upper portion 2024a of the second gate stack 2024 may be formed by removing the first sacrificial material 1102 and depositing the first gate dielectric 1912 and the first gate electrode 1910 around the upper two semiconductor regions 2020a and 2020b. The lower portion 2024b of the second gate stack 2024 may be formed by removing the second sacrificial material 1104 and depositing the second gate dielectric 1916 and the second gate electrode 1914 around the exposed semiconductor region 2020c. Individuated stacks of nanoribbons may be formed as described with respect to FIGs. 3 and 10.

Using different gate materials in the transistor can result in a transistor that has two power modes. A lower threshold voltage may cause current to flow across a first semiconductor region or first set of semiconductor regions (e.g., the semiconductor region 2020b, which is controlled by the first portion 2024a of the second gate stack 2024a), while a higher threshold voltage may cause current to flow across one or more additional semiconductor regions (e.g., both semiconductor regions 2020b and 2020c). For example, using different electrode materials (e.g., the gate electrodes 1910 and 1914) may provide different work functions at different semiconductor regions (e.g., the semiconductor regions 2020b and 2020c, respectively), which may result in different threshold voltages at different nanoribbons of a single transistor.

### Example devices

The circuit devices with stacked transistors with independent gates disclosed herein may be included in any suitable electronic device. FIGS. 21-25 illustrate various examples of apparatuses that may include the one or more transistors or memory cells disclosed herein, which may have been fabricated using the processes disclosed herein.

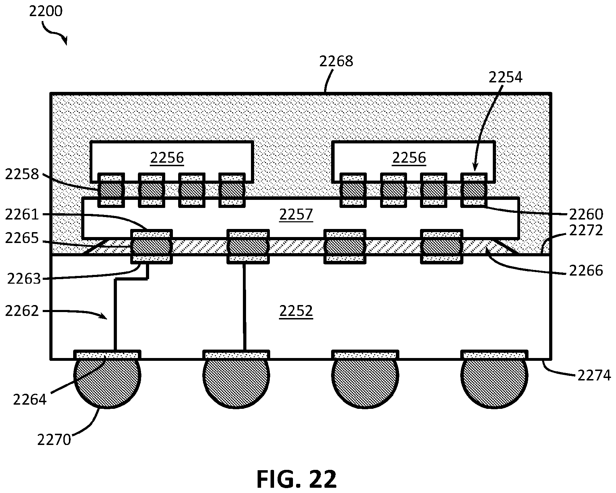

FIG. 21 illustrates top views of a wafer 2100 and dies 2102 that may include one or more stacked transistors with independent gates in accordance with any of the embodiments disclosed herein. In some embodiments, the dies 2102 may be included in an IC package, in accordance with any of the embodiments disclosed herein. For example, any of the dies 2102 may serve as any of the dies 2256 in an IC package 2200 shown in FIG. 22. The wafer 2100 may be composed of semiconductor material and may include one or more dies 2102 having IC structures formed on a surface of the wafer 2100. Each of the dies 2102 may be a repeating unit of a semiconductor product that includes any suitable IC (e.g., ICs including one or more stacked transistors with independent gates as described herein). After the fabrication of the semiconductor product is complete (e.g., after manufacture of any embodiment of the IC device 100 as described herein), the wafer 2100 may undergo a singulation process in which each of the dies 2102 is separated from one another to provide discrete "chips" of the semiconductor product. In particular, devices that include one or more stacked transistors with independent gates as disclosed herein may take the form of the wafer 2100 (e.g., not singulated) or the form of the die 2102 (e.g., singulated). The die 2102 may include supporting circuitry to route electrical signals to various memory cells, transistors, capacitors, as well as any other IC components. In some embodiments, the wafer 2100 or the die 2102 may implement or include a memory device (e.g., a hysteretic memory device), a logic device (e.g., an AND, OR, NAND, or NOR gate), or any other suitable circuit element. Multiple ones of these devices may be combined on a single die 2102. For example, a memory array formed by multiple memory devices may be formed on a same die 2102 as a processing device (e.g., the processing device 2402 of FIG. 22) or other logic that is configured to store information in the memory devices or execute instructions stored in the memory array.

FIG. 22 is a side, cross-sectional view of an example IC package 2200 that may include one or more stacked transistors with independent gates in accordance with any of the embodiments disclosed herein. In some embodiments, the IC package 2200 may be a system-in-package (SiP).

The package substrate 2252 may be formed of a dielectric material (e.g., a ceramic, a buildup film, an epoxy film having filler particles therein, etc.), and may have conductive pathways extending through the dielectric material between the face 2272 and the face 2274, or between different locations on the face 2272, and/or between different locations on the face 2274.

The package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

The IC package 2200 may include an interposer 2257 coupled to the package substrate 2252 via conductive contacts 2261 of the interposer 2257, first-level interconnects 2265, and the conductive contacts 2263 of the package substrate 2252. The first-level interconnects 2265 illustrated in FIG. 22 are solder bumps, but any suitable first-level interconnects 2265 may be used. In some embodiments, no interposer 2257 may be included in the IC package 2200; instead, the dies 2256 may be coupled directly to the conductive contacts 2263 at the face 2272 by first-level interconnects 2265.

The IC package 2200 may include one or more dies 2256 coupled to the interposer 2257 via conductive contacts 2254 of the dies 2256, first-level interconnects 2258, and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 22 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

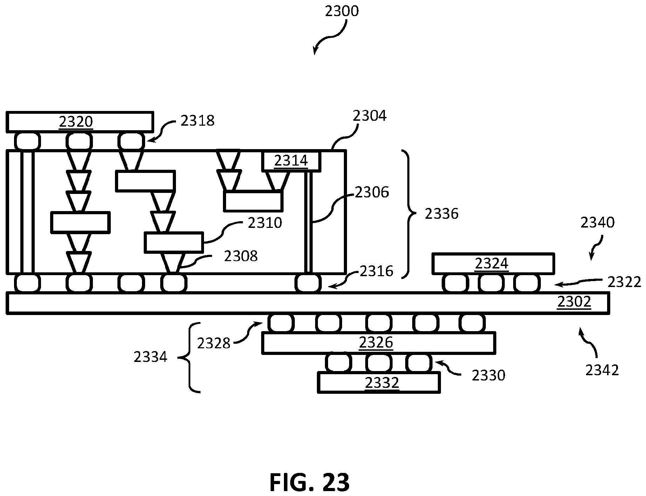

In some embodiments, an underfill material 2266 may be disposed between the package substrate 2252 and the interposer 2257 around the first-level interconnects 2265, and a mold compound 2268 may be disposed around the dies 2256 and the interposer 2257 and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 22 are solder balls (e.g., for a ball grid array arrangement), but any suitable second-level interconnects 22770 may be used (e.g., pins in a pin grid array arrangement or lands in a land grid array arrangement). The second-level interconnects 2270 may be used to couple the IC package 2200 to another component, such as a circuit board (e.g., a motherboard), an interposer, or another IC package, as known in the art and as discussed below with reference to FIG. 23.

The dies 2256 may take the form of any of the embodiments of the die 2102 discussed herein (e.g., may include any of the embodiments of the IC devices with one or more stacked transistors with independent gates as described herein). In embodiments in which the IC package 2200 includes multiple dies 2256, the IC package 2200 may be referred to as a multi-chip package (MCP). The dies 2256 may include circuitry to perform any desired functionality. For example, one or more of the dies 2256 may be logic dies (e.g., silicon-based dies), and one or more of the dies 2256 may be memory dies (e.g., high bandwidth memory), including embedded memory dies as described herein. In some embodiments, any of the dies 2256 may include one or more IC devices with one or more stacked transistors with independent gates, e.g., as discussed above; in some embodiments, at least some of the dies 2256 may not include any stacked transistors with independent gates.

The IC package 2200 illustrated in FIG. 22 may be a flip chip package, although other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fan-out (FO) package. Although two dies 2256 are illustrated in the IC package 2200 of FIG. 22, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257. More generally, an IC package 2200 may include any other active or passive components known in the art.

FIG. 23 is a cross-sectional side view of an IC device assembly 2300 that may include components having one or more stacked transistors with independent gates in accordance with any of the embodiments disclosed herein. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. In particular, any suitable ones of the components of the IC device assembly 2300 may include any of one or more stacked transistors with independent gates in accordance with any of the embodiments disclosed herein; e.g., any of the IC packages discussed below with reference to the IC device assembly 2300 may take the form of any of the embodiments of the IC package 2200 discussed above with reference to FIG. 22 (e.g., may include one or more stacked transistors with independent gates provided on a die 2256).

In some embodiments, the circuit board 2302 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 23 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (e.g., as shown in FIG. 23), male and female portions of a socket, an adhesive, an underfill material, and/or any other suitable electrical and/or mechanical coupling structure.

The package-on-interposer structure 2336 may include an IC package 2320 coupled to an interposer 2304 by coupling components 2318. The coupling components 2318 may take any suitable form for the application, such as the forms discussed above with reference to the coupling components 2316. The IC package 2320 may be or include, for example, a die (the die 2102 of FIG. 21), an IC device, or any other suitable component. In particular, the IC package 2320 may include one or more stacked transistors with independent gates as described herein. Although a single IC package 2320 is shown in FIG. 23, multiple IC packages may be coupled to the interposer 2304; indeed, additional interposers may be coupled to the interposer 2304. The interposer 2304 may provide an intervening substrate used to bridge the circuit board 2302 and the IC package 2320. Generally, the interposer 2304 may spread a connection to a wider pitch or reroute a connection to a different connection. For example, the interposer 2304 may couple the IC package 2320 (e.g., a die) to a BGA of the coupling components 2316 for coupling to the circuit board 2302. In the embodiment illustrated in FIG. 23, the IC package 2320 and the circuit board 2302 are attached to opposing sides of the interposer 2304; in other embodiments, the IC package 2320 and the circuit board 2302 may be attached to a same side of the interposer 2304. In some embodiments, three or more components may be interconnected by way of the interposer 2304.

The interposer 2304 may be formed of an epoxy resin, a fiberglass-reinforced epoxy resin, a ceramic material, or a polymer material such as polyimide. In some implementations, the interposer 2304 may be formed of alternate rigid or flexible materials that may include the same materials described above for use in a semiconductor substrate, such as silicon, germanium, and other group III-V and group IV materials. The interposer 2304 may include metal interconnects 2308 and vias 2310, including but not limited to through-silicon vias (TSVs) 2306. The interposer 2304 may further include embedded devices 2314, including both passive and active devices. Such devices may include, but are not limited to, capacitors, decoupling capacitors, resistors, inductors, fuses, diodes, transformers, sensors, electrostatic discharge (ESD) protection devices, and memory devices. More complex devices such as radio frequency (RF) devices, power amplifiers, power management devices, antennas, arrays, sensors, and microelectromechanical systems (MEMS) devices may also be formed on the interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 23 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

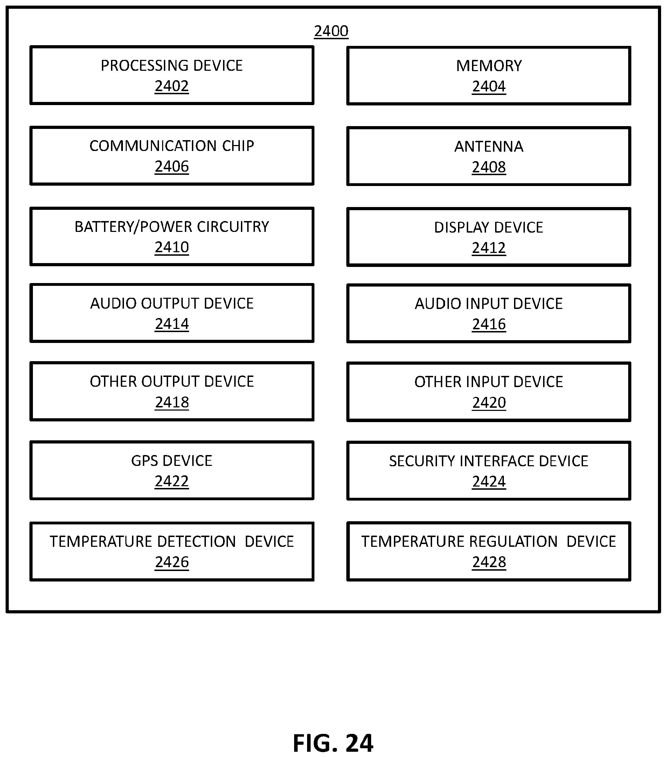

FIG. 24 is a block diagram of an example computing device 2400 that may include one or more components including one or more IC devices with one or more stacked transistors with independent gates in accordance with any of the embodiments disclosed herein. For example, any suitable ones of the components of the computing device 2400 may include a die (e.g., the die 2102 of FIG. 21) having one or more stacked transistors with independent gates as described herein. Any one or more of the components of the computing device 2400 may include, or be included in, an IC package 2200 of FIG. 22 or an IC device 2300 of FIG. 23.

A number of components are illustrated in FIG. 24 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single system-on-a-chip (SoC) die.

Additionally, in various embodiments, the computing device 2400 may not include one or more of the components illustrated in FIG. 24, but the computing device 2400 may include interface circuitry for coupling to the one or more components. For example, the computing device 2400 may not include a display device 2412, but may include display device interface circuitry (e.g., a connector and driver circuitry) to which a display device 2412 may be coupled. In another set of examples, the computing device 2400 may not include an audio input device 2416 or an audio output device 2414, but may include audio input or output device interface circuitry (e.g., connectors and supporting circuitry) to which an audio input device 2416 or audio output device 2414 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), nonvolatile memory (e.g., read-only memory (ROM)), flash memory, solid state memory, and/or a hard drive. In some embodiments, the memory 2404 may include memory that shares a die with the processing device 2402. This memory may be used as cache memory and may include embedded DRAM (eDRAM) or spin transfer torque magnetic random-access memory (STT-MRAM).

In some embodiments, the computing device 2400 may include a communication chip 2406 (e.g., one or more communication chips). For example, the communication chip 2406 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2406 may implement any of a number of wireless standards or protocols, including but not limited to Institute for Electrical and Electronic Engineers (IEEE) standards including Wi-Fi (IEEE 1402.11 family), IEEE 1402.16 standards (e.g., IEEE 1402.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 1402.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 1402.16 standards. The communication chip 2406 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2406 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2406 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2406 may operate in accordance with other wireless protocols in other embodiments. The computing device 2400 may include an antenna 2408 to facilitate wireless communications and/or to receive other wireless communications (such as AM or FM radio transmissions).

In some embodiments, the communication chip 2406 may manage wired communications, such as electrical, optical, or any other suitable communication protocols (e.g., the Ethernet). As noted above, the communication chip 2406 may include multiple communication chips. For instance, a first communication chip 2406 may be dedicated to shorter-range wireless communications such as Wi-Fi or Bluetooth, and a second communication chip 2406 may be dedicated to longer-range wireless communications such as global positioning system (GPS), EDGE, GPRS, CDMA, WiMAX, LTE, EV-DO, or others. In some embodiments, a first communication chip 2406 may be dedicated to wireless communications, and a second communication chip 2406 may be dedicated to wired communications.

The computing device 2400 may include a battery/power circuitry 2410. The battery/power circuitry 2410 may include one or more energy storage devices (e.g., batteries or capacitors) and/or circuitry for coupling components of the computing device 2400 to an energy source separate from the computing device 2400 (e.g., AC line power).

The computing device 2400 may include a display device 2412 (or corresponding interface circuitry, as discussed above). The display device 2412 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2414 (or corresponding interface circuitry, as discussed above). The audio output device 2414 may include any device that generates an audible indicator, such as speakers, headsets, or earbuds, for example.

The computing device 2400 may include an audio input device 2416 (or corresponding interface circuitry, as discussed above). The audio input device 2416 may include any device that generates a signal representative of a sound, such as microphones, microphone arrays, or digital instruments (e.g., instruments having a musical instrument digital interface (MIDI) output).

The computing device 2400 may include an other output device 2418 (or corresponding interface circuitry, as discussed above). Examples of the other output device 2418 may include an audio codec, a video codec, a printer, a wired or wireless transmitter for providing information to other devices, or an additional storage device.

The computing device 2400 may include an other input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may include a GPS device 2422 (or corresponding interface circuitry, as discussed above). The GPS device 2422 may be in communication with a satellite-based system and may receive a location of the computing device 2400, as known in the art.

The computing device 2400 may include a security interface device 2424. The security interface device 2424 may include any device that provides security features for the computing device 2400 or for any individual components therein (e.g., for the processing device 2402 or for the memory 2404). Examples of security features may include authorization, access to digital certificates, access to items in keychains, etc. Examples of the security interface device 2424 may include a software firewall, a hardware firewall, an antivirus, a content filtering device, or an intrusion detection device.

In some embodiments, the computing device 2400 may include a temperature detection device 2426 and a temperature regulation device 2428.

The temperature detection device 2426 may include any device capable of determining temperatures of the computing device 2400 or of any individual components therein (e.g., temperatures of the processing device 2402 or of the memory 2404). In various embodiments, the temperature detection device 2426 may be configured to determine temperatures of an object (e.g., the computing device 2400, components of the computing device 2400, devices coupled to the computing device, etc.), temperatures of an environment (e.g., a data center that includes, is controlled by, or otherwise associated with the computing device 2400), and so on. The temperature detection device 2426 may include one or more temperature sensors. Different temperature sensors of the temperature detection device 2426 may have different locations within and around the computing device 2400. A temperature sensor may generate data (e.g., digital data) representing detected temperatures and provide the data to another device, e.g., to the temperature regulation device 2428, the processing device 2402, the memory 2404, etc. In some embodiments, a temperature sensor of the temperature detection device 2426 may be turned on or off, e.g., by the processing device 2402 or an external system. The temperature sensor detects temperatures when it is on and does not detect temperatures when it is off. In other embodiments, a temperature sensor of the temperature detection device 2426 may detect temperatures continuously and automatically or detect temperatures at predefined times or at times triggered by an event associated with the computing device 2400 or any components therein.

The temperature regulation device 2428 may include any device configured to change (e.g., decrease) temperatures, e.g., based on one or more target temperatures and/or based on temperature measurements performed by the temperature detection device 2426. A target temperature may be a preferred temperature. A target temperature may depend on a setting in which the computing device 2400 operates. In some embodiments, the target temperature may be 200 Kelvin degrees or lower. In some embodiments, the target temperature may be 20 Kelvin degrees or lower, or 5 Kelvin degrees or lower. Target temperatures for different objects and different environments of, or associated with, the computing device 2400 can be different. In some embodiments, cooling provided by the temperature regulation device 2428 may be a multi-stage process with temperatures ranging from room temperature to 4K or lower.

In some embodiments, the temperature regulation device 2428 may include one or more cooling devices. Different cooling device may have different locations within and around the computing device 2400. A cooling device of the temperature regulation device 2428 may be associated with one or more temperature sensors of the temperature detection device 2426 and may be configured to operate based on temperatures detected the temperature sensors. For instance, a cooling device may be configured to determine whether a detected ambient temperature is above the target temperature or whether the detected ambient temperature is higher than the target temperature by a predetermined value or determine whether any other temperature-related condition associated with the temperature of the computing device 2400 is satisfied. In response to determining that one or more temperature-related condition associated with the temperature of the computing device 2400 are satisfied (e.g., in response to determining that the detected ambient temperature is above the target temperature), a cooling device may trigger its cooling mechanism and start to decrease the ambient temperature. Otherwise, the cooling device does not trigger any cooling. A cooling device of the temperature regulation device 2428 may operate with various cooling mechanisms, such as evaporation cooling, radiation cooling, conduction cooling, convection cooling, other cooling mechanisms, or any combination thereof. A cooling device of the temperature regulation device 2428 may include a cooling agent, such as a water, oil, liquid nitrogen, liquid helium, etc. In some embodiments, the temperature regulation device 2428 may be, for example, a dilution refrigerator, a helium-3 refrigerator, or a liquid helium refrigerator. In some embodiments, the temperature regulation device 2428 or any portions thereof (e.g., one or more of the individual cooling devices) may be connected to the computing device 2400 in close proximity (e.g., less than about 1 meter) or may be provided in a separate enclosure where a dedicated heat exchanger (e.g., a compressor, a heating, ventilation, and air conditioning (HVAC) system, liquid helium, liquid nitrogen, etc.) may reside.

By maintaining the target temperatures, the energy consumption of the computing device 2400 (or components thereof) can be reduced, while the computing efficiency may be improved. For example, when the computing device 2400 (or components thereof) operates at lower temperatures, energy dissipation (e.g., heat dissipation) may be reduced. Further, energy consumed by semiconductor components (e.g., energy needed for switching transistors of any of the components of the computing device 2400) can also be reduced. Various semiconductor materials may have lower resistivity and/or higher mobility at lower temperatures. That way, the electrical current per unit supply voltage may be increased by lowering temperatures. Conversely, for the same current that would be needed, the supply voltage may be lowered by lowering temperatures. As energy corelates to the supply voltage, the energy consumption of the semiconductor components may lower too. In some implementations, the energy savings due to reducing heat dissipation and reducing energy consumed by semiconductor components of the computing device or components thereof may outweigh (sometimes significantly outweigh) the costs associated with energy needed for cooling.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

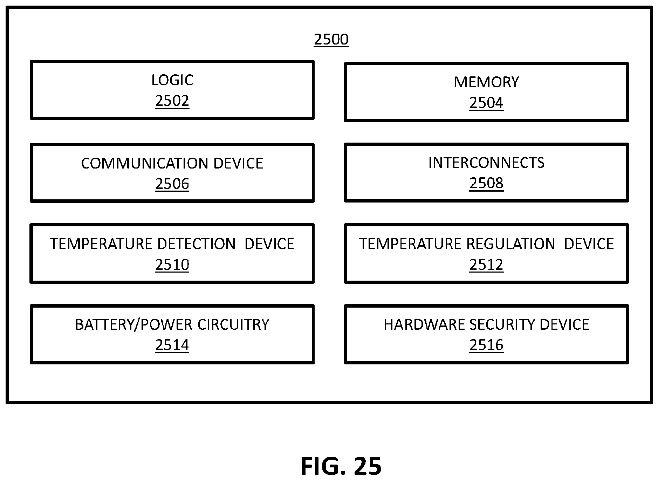

FIG. 25 is a block diagram of an example processing device 2500 that may include one or more IC devices with one or more stacked transistors with independent gates in accordance with any of the embodiments disclosed herein. For example, any suitable ones of the components of the processing device 2500 may include a die (e.g., the die 2102 of FIG. 21) having one or more stacked transistors with independent gates as described herein. Any one or more of the components of the processing device 2500 may include, or be included in, an IC device 1400 (FIG. 23). Any one or more of the components of the processing device 2500 may include, or be included in, an IC package 2200 of FIG. 22 or an IC device 2300 of FIG. 23. Any one or more of the components of the processing device 2500 may include, or be included in, a computing device 2400 of FIG. 24; for example, the processing device 2500 may be the processing device 2402 of the computing device 2400.

A number of components are illustrated in FIG. 25 as included in the processing device 2500, but any one or more of these components may be omitted or duplicated, as suitable for the application. In some embodiments, some or all of the components included in the processing device 2500 may be attached to one or more motherboards. In some embodiments, some or all of these components are fabricated on a single SoC die or coupled to a single support structure, e.g., to a single carrier substrate.

Additionally, in various embodiments, the processing device 2500 may not include one or more of the components illustrated in FIG. 25, but the processing device 2500 may include interface circuitry for coupling to the one or more components. For example, the processing device 2500 may not include a memory 2504, but may include display device interface circuitry (e.g., a connector and driver circuitry) to which a memory 2504 may be coupled.

The processing device 2500 may include logic circuitry 2502 (e.g., one or more circuits configured to implement logic/compute functionality). Examples of such circuits include ICs implementing one or more of input/output (I/O) functions, arithmetic operations, pipelining of data, etc.

In some embodiments, the logic circuitry 2502 may include one or more circuits responsible for read/write operations with respect to the data stored in the memory 2504. To that end, the logic circuitry 2502 may include one or more I/O ICs configured to control access to data stored in the memory 2504.

In some embodiments, the logic circuitry 2502 may include one or more high-performance compute dies, configured to perform various operations with respect to data stored in the memory 2504 (e.g., arithmetic and logic operations, pipelining of data from one or more memory dies of the memory 2504, and possibly also data from external devices/chips). In some embodiments, the logic circuitry 2502 may be configured to only control I/O access to data but not perform any operations on the data. In some embodiments, the logic circuitry 2502 may implement ICs configured to implement I/O control of data stored in the memory 2504, assemble data from the memory 2504 for transport (e.g., transport over a central bus) to devices/chips that are either internal or external to the processing device 2500, etc. In some embodiments, the logic circuitry 2502 may not be configured to perform any operations on the data besides I/O and assembling for transport to the memory 2504.

The processing device 2500 may include a memory 2504, which may include one or more ICs configure to implement memory circuitry (e.g., ICs implementing one or more of memory devices, memory arrays, control logic configured to control the memory devices and arrays, etc.). In some embodiments, the memory 2504 may be implemented substantially as described above with reference to the memory 1604 (FIG. 24). In some embodiments, the memory 2504 may be a designated device configured to provide storage functionality for the components of the processing device 2500 (i.e., local), while the memory 1604 may be configured to provide system-level storage functionality for the entire computing device 1600 (i.e., global). In some embodiments, the memory 2504 may include memory that shares a die with the logic circuitry 2502.

In some embodiments, the memory 2504 may include a flat memory (also sometimes referred to as a "flat hierarchy memory" or a "linear memory") and, therefore, may also be referred to as a "basin memory." As known in the art, a flat memory or a linear memory refers to a memory addressing paradigm in which memory may appear to the program as a single contiguous address space, where a processor can directly and linearly address all of the available memory locations without having to resort to memory segmentation or paging schemes. Thus, the memory implemented in the memory 2504 may be a memory that is not divided into hierarchical layer or levels in terms of access of its data.

In some embodiments, the memory 2504 may include a hierarchical memory. In this context, hierarchical memory refers to the concept of computer architecture where computer storage is separated into a hierarchy based on features of memory such as response time, complexity, capacity, performance, and controlling technology. Designing for high performance may require considering the restrictions of the memory hierarchy, i.e., the size and capabilities of each component. With hierarchical memory, each of the various memory components can be viewed as part of a hierarchy of memories (m₁, m₂, ..., mₙ) in which each member mᵢ is typically smaller and faster than the next highest member m_{¡+1} of the hierarchy. To limit waiting by higher levels, a lower level of a hierarchical memory structure may respond by filling a buffer and then signaling for activating the transfer. For example, in some embodiments, the hierarchical memory implemented in the memory 2504 may be separated into four major storage levels: 1) internal storage (e.g., processor registers and cache), 2) main memory (e.g., the system RAM and controller cards), and 3) on-line mass storage (e.g., secondary storage), and 4) off-line bulk storage (e.g., tertiary, and off-line storage). However, as the number of levels in the memory hierarchy and the performance at each level has increased over time and is likely to continue to increase in the future, this example hierarchical division provides only one non-limiting example of how the memory 2504 may be arranged.

The processing device 2500 may include a communication device 2506, which may be implemented substantially as described above with reference to the communication chip 1606 (FIG. 24). In some embodiments, the communication device 2506 may be a designated device configured to provide communication functionality for the components of the processing device 2500 (i.e., local), while the communication chip 1606 may be configured to provide system-level communication functionality for the entire computing device 1600 (i.e., global).

The processing device 2500 may include interconnects 2508, which may include any element or device that includes an electrically conductive material for providing electrical connectivity to one or more components of, or associated with, a processing device 2500 or/and between various such components. Examples of the interconnects 2508 include conductive lines/wires (also sometimes referred to as "lines" or "metal lines" or "trenches") and conductive vias (also sometimes referred to as "vias" or "metal vias"), metallization stacks, redistribution layers, metal-insulator-metal (MIM) structures, etc.

The processing device 2500 may include a temperature detection device 2510 which may be implemented substantially as described above with reference to the temperature detection device 2426 of FIG. 24 but configured to determine temperatures on a more local scale, i.e., of the processing device 2500 of components thereof. In some embodiments, the temperature detection device 2510 may be a designated device configured to provide temperature detection functionality for the components of the processing device 2500 (i.e., local), while the temperature detection device 2426 may be configured to provide system-level temperature detection functionality for the entire computing device 2400 (i.e., global).

The processing device 2500 may include a temperature regulation device 2512 which may be implemented substantially as described above with reference to the temperature regulation device 2428 of FIG. 24 but configured to regulate temperatures on a more local scale, i.e., of the processing device 2500 of components thereof. In some embodiments, the temperature regulation device 2512 may be a designated device configured to provide temperature regulation functionality for the components of the processing device 2500 (i.e., local), while the temperature regulation device 2428 may be configured to provide system-level temperature regulation functionality for the entire computing device 2400 (i.e., global).

The processing device 2500 may include a battery/power circuitry 2514 which may be implemented substantially as described above with reference to the battery/power circuitry 2410 of FIG. 24. In some embodiments, the battery/power circuitry 2514 may be a designated device configured to provide battery/power functionality for the components of the processing device 2500 (i.e., local), while the battery/power circuitry 2410 may be configured to provide system-level battery/power functionality for the entire computing device 2400 (i.e., global).

The processing device 2500 may include a hardware security device 2516 which may be implemented substantially as described above with reference to the security interface device 2424 of FIG. 24. In some embodiments, the hardware security device 2516 may be a physical computing device configured to safeguard and manage digital keys, perform encryption and decryption functions for digital signatures, authentication, and other cryptographic functions. In some embodiments, the hardware security device 2516 may include one or more secure cryptoprocessors chips.

The above description of illustrated implementations of the disclosure, including what is described in the Abstract, is not intended to be exhaustive or to limit the disclosure to the precise forms disclosed. Unless specified otherwise, in various embodiments, features described with respect to one of the drawings may be combined with those described with respect to other drawings.

### Select examples

The following paragraphs provide various examples of the embodiments disclosed herein.

Example 1 provides a device including a plurality of semiconductor regions arranged in a stack, each of the plurality of semiconductor regions having a first end and a second end; a source or drain region coupled to the plurality of semiconductor regions at the first end of the respective semiconductor regions; a first gate region coupled to a first and a second of the plurality of semiconductor regions, the first and second semiconductor regions adjacent to each other in the stack; and a second gate region coupled to at least a third of the plurality of semiconductor regions, the second gate region electrically isolated from the first gate region, and the third semiconductor region adjacent to the second semiconductor region in the stack; where a first distance between the first and second semiconductor regions is less than a second distance between the second and third semiconductor regions.

Example 2 provides the device of example 1, where the second gate region is coupled to only one semiconductor region.

Example 3 provides the device of example 1 or 2, further including a third gate region coupled to at least a fourth of the plurality of semiconductor regions, the third gate region electrically isolated from the first gate region and the second gate region.

Example 4 provides the device of any preceding example, where a first direction is a direction from the first end to the second end of one of the semiconductor regions, and the first gate region and the second gate region each extend along a respective gate line in a second direction perpendicular to the first direction.

Example 5 provides the device of example 4, where a first gate via is coupled to the first gate region, a second gate via is coupled to the second gate region, the first gate via and the second gate via having different lengths.

Example 6 provides the device of any preceding example, further including a second plurality of semiconductor regions arranged in a second stack, where the second gate region is further coupled to at least one of the second plurality of semiconductor regions in the second stack.

Example 7 provides the device of any preceding example, further including a second source or drain region coupled to the plurality of semiconductor regions at the second end of the respective semiconductor regions.

Example 8 provides the device of any preceding example, where the first gate region includes a first conductor, the second gate region includes a second conductor, and the first conductor includes a different material from the second conductor.

Example 9 provides the device of any preceding example, where the first gate region includes a first dielectric and a first conductor, the second gate region includes a second dielectric and a second conductor, and the first dielectric includes a different material from the second dielectric.

Example 10 provides the device of any preceding example, where the first semiconductor region and the third semiconductor region include different semiconductor materials.

Example 11 provides the device of any preceding example, where the first semiconductor region and the second semiconductor region include different semiconductor materials.

Example 12 provides an integrated circuit (IC) device including a plurality of semiconductor regions arranged in a stack, each of the plurality of semiconductor regions having a first end and a second end; a source or drain region coupled to the plurality of semiconductor regions at the first end of the respective semiconductor regions; a first gate region coupled to a first semiconductor region of the stack, the first gate region including a first dielectric layer and a first conductive layer; and a second gate region coupled to a second semiconductor region of the stack, the second gate region including a second dielectric layer and a second conductive layer, where the first dielectric layer includes a different dielectric material from the second dielectric layer.

Example 13 provides the IC device of example 12, where the first conductive layer includes a different conductive material from the second conductive layer.

Example 14 provides the IC device of example 13, where the first gate material has a first work function, and the second gate material has a second work function different from the first work function.

Example 15 provides the IC device of any of examples 12-14, where, the second gate region is in physical contact with the first gate region.

Example 16 provides the IC device of any of examples 12-14, where, the second gate region is physically isolated from the first gate region.

Example 17 provides the IC device of example 16, where the second gate region is further coupled to a third semiconductor region of the stack.

Example 18 provides the IC device of example 16 or 17, further including a third dielectric layer between the first conductive layer and the second conductive layer.

Example 19 provides the IC device of any of examples 12-18, further including a third gate region coupled to a third semiconductor region of the stack.

Example 20 provides an assembly including a circuit board; and an integrated circuit (IC) device coupled to the circuit board, the IC device including a first transistor including a first number of semiconductor nanoribbons and a first gate; and a second transistor stacked over the first transistor, the second transistor including a second number of semiconductor nanoribbons and a second gate, the first gate and the second gate are physically separated from each other, and the first number of semiconductor nanoribbons is different from the second number of semiconductor nanoribbons.

Example 21 provides the assembly of example 20, where the first transistor includes an even number of semiconductor nanoribbons, and the second transistor includes an odd number of semiconductor nanoribbons.

Example 22 provides the assembly of example 20, where the first transistor includes an odd number of semiconductor nanoribbons, and the second transistor includes an even number of semiconductor nanoribbons.

Example 23 provides the assembly of any of examples 20-22, where the first gate is coupled to a first via, and the second gate is coupled to a second via.

Example 24 provides the assembly of any of examples 20-23, where one of the first transistor and the second transistor include a first semiconductor nanoribbon and a second semiconductor nanoribbon, the first semiconductor nanoribbon including a different semiconductor material from the second semiconductor nanoribbon.

Example 25 provides the assembly of example 24, where a first threshold voltage for the first semiconductor nanoribbon is different from a second threshold voltage for the second semiconductor nanoribbon.

Example 26 provides a method including forming a stack of materials, the stack including a plurality of semiconductor layers, a first sacrificial material, and a second sacrificial material; removing at least a portion of the first sacrificial material to expose at least a portion of a first semiconductor layer of the plurality of semiconductor layers; depositing a first gate stack around the first semiconductor layer; removing at least a portion of the second sacrificial material to expose at least a portion of a second semiconductor layer of the plurality of semiconductor layers; and depositing a second gate stack around the second semiconductor layer.

Example 27 provides the method of example 26, where the first semiconductor layer includes a different semiconductor material from the second semiconductor layer.

Example 28 provides the method of example 26 or 27, where the first semiconductor layer and the second semiconductor layer are nanoribbons.

Example 29 provides the method of any of examples 26-28, where forming the stack of materials includes forming a first portion of the stack of materials; forming a second portion of the stack of materials; and transferring the second portion onto an upper surface of the first portion.

Example 30 provides the method of any of examples 26-28, where forming the stack of materials includes depositing at least one of the plurality of semiconductor layers as thin film.

Example 31 provides an IC package that includes an IC die, including one or more of the IC devices according to any one of the preceding examples. The IC package may also include a further component, coupled to the IC die.

Example 32 provides the IC package according to example 31, where the further component is one of a package substrate, a flexible substrate, or an interposer.

Example 33 provides the IC package according to examples 31 or 32, where the further component is coupled to the IC die via one or more first level interconnects.

Example 34 provides the IC package according to example 33, where the one or more first level interconnects include one or more solder bumps, solder posts, or bond wires.

Example 35 provides a computing device that includes a circuit board; and an IC die coupled to the circuit board, where the IC die includes one or more of the transistor/IC devices according to any one of the preceding examples (e.g., transistor/IC devices according to any one of examples 1-30), and/or the IC die is included in the IC package according to any one of the preceding examples (e.g., the IC package according to any one of examples 31-34).

Example 36 provides the computing device according to example 35, where the computing device is a wearable computing device (e.g., a smart watch) or hand-held computing device (e.g., a mobile phone).

Example 37 provides the computing device according to examples 35 or 36, where the computing device is a server processor.

Example 38 provides the computing device according to examples 35 or 36, where the computing device is a motherboard.

Example 39 provides the computing device according to any one of examples 35-38, where the computing device further includes one or more communication chips and an antenna.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. A device comprising:
a plurality of semiconductor regions arranged in a stack, each of the plurality of semiconductor regions having a first end and a second end;
a source or drain region coupled to the plurality of semiconductor regions at the first end of the respective semiconductor regions;
a first gate region coupled to a first and a second of the plurality of semiconductor regions, the first and second semiconductor regions adjacent to each other in the stack; and
a second gate region coupled to at least a third of the plurality of semiconductor regions, the second gate region electrically isolated from the first gate region, and the third semiconductor region adjacent to the second semiconductor region in the stack;
wherein a first distance between the first and second semiconductor regions is less than a second distance between the second and third semiconductor regions.

2. The device of claim 1, wherein the second gate region is coupled to only one semiconductor region.

3. The device of claim 1, further comprising a third gate region coupled to at least a fourth of the plurality of semiconductor regions, the third gate region electrically isolated from the first gate region and the second gate region.

4. The device of claim 1, wherein a first direction is a direction from the first end to the second end of one of the semiconductor regions, and the first gate region and the second gate region each extend along a respective gate line in a second direction perpendicular to the first direction.

5. The device of claim 4, wherein a first gate via is coupled to the first gate region, a second gate via is coupled to the second gate region, the first gate via and the second gate via having different lengths.

6. The device of claim 1, further comprising a second plurality of semiconductor regions arranged in a second stack, wherein the second gate region is further coupled to at least one of the second plurality of semiconductor regions in the second stack.

7. The device of claim 1, further comprising a second source or drain region coupled to the plurality of semiconductor regions at the second end of the respective semiconductor regions.

8. The device of claim 1, wherein the first gate region comprises a first conductor, the second gate region comprises a second conductor, and the first conductor includes a different material from the second conductor.

9. The device of claim 1, wherein the first gate region comprises a first dielectric and a first conductor, the second gate region comprises a second dielectric and a second conductor, and the first dielectric includes a different material from the second dielectric.

10. The device of claim 1, wherein the first semiconductor region and the third semiconductor region comprise different semiconductor materials.

11. The device of claim 1, wherein the first semiconductor region and the second semiconductor region comprise different semiconductor materials.

12. An integrated circuit (IC) device comprising:
a plurality of semiconductor regions arranged in a stack, each of the plurality of semiconductor regions having a first end and a second end;
a source or drain region coupled to the plurality of semiconductor regions at the first end of the respective semiconductor regions;
a first gate region coupled to a first semiconductor region of the stack, the first gate region comprising a first dielectric layer and a first conductive layer; and
a second gate region coupled to a second semiconductor region of the stack, the second gate region comprising a second dielectric layer and a second conductive layer, wherein the first dielectric layer includes a different dielectric material from the second dielectric layer.

13. The IC device of claim 12, wherein the first conductive layer comprises a different conductive material from the second conductive layer.

14. The IC device of claim 13, wherein the first gate material has a first work function, and the second gate material has a second work function different from the first work function.

15. The IC device of claim 12, wherein, the second gate region is in physical contact with the first gate region.
